# EUROPEAN PATENT APPLICATION

(11) **EP 2 468 920 A2**
(43) Date of publication of application: **27.06.2012**
(21) Application number: 11192322.3
(22) Date of filing: 07.12.2011
(51) Int. Cl.: C23C 14/34, B29C 45/00, B32B 15/08

(54) **Resin product manufacturing system**

(30) Priority: 24.12.2010 JP 2010288291
(71) Applicant: Kojima Press Industry Co., Ltd., Toyota-shi, Aichi 471-0875 (JP)
(72) Inventor: Ito, Kaoru, Toyota-shi, Aichi 471-0875 (JP); Morioka, Yasuyuki, Toyota-shi, Aichi 471-0875 (JP); Hayakawa, Munetaka, Toyota-shi, Aichi 471-0875 (JP); Ito, Takaaki, Toyota-shi, Aichi 471-0875 (JP)
(74) Representative: Naylor, Matthew John

(57) **Abstract**

A resin product manufacturing system includes: molding apparatuses for forming substrates; a substrate removal apparatus for removing the substrates from the molding apparatuses; a metal film deposition apparatus for forming a metal film on the substrates to obtain intermediate products; a substrate carrying machine for carrying the substrates into the metal film deposition apparatus; an intermediate product removal machine for removing the intermediate products from the metal film deposition apparatus; a coating film forming apparatus for forming a coating film on the intermediate products to obtain resin products; an intermediate product carrying machine for carrying the intermediate products into the coating film forming apparatus; first and second transfer apparatuses for transferring the substrates; a first control unit for controlling the substrate removal apparatus; a second control unit for controlling the intermediate product removal apparatus and the metal film deposition apparatus; and a third control unit for controlling the carrying machine.

## Description

### BACKGROUND OF THE INVENTION

### Field of the Invention

The present invention relates to a resin product manufacturing system, and in particular to an improvement of a resin product manufacturing system that manufactures a resin product including a substrate formed of a resin molded article, and a laminate of a metal film and a coating film formed on a surface of the substrate.

### Discussion of Related Art

Conventionally, as disclosed in JP-A-2004-174921, for example, a resin product including a substrate formed of a resin molded article and a metallic film formed on a surface of the substrate by sputtering is well known. Generally, an undercoat layer formed of a predetermined coating film is formed between the substrate and the metal film, of the resin product, to improve the adhesion of the metal film to the surface of the substrate. Further, a topcoat layer, which is formed of a transparent coating film, is formed on the metal film to protect the metal film. Such resin products are widely used for automobile interior parts, furniture, building materials, home electric appliances, and mobile electronic apparatuses, for example, as replacements of metal products. Further, the resin product is used as a part of a touch panel which includes the metal film as an electrode film, for example.

JP-A-2010-89399 proposes a resin product including a metal film formed directly on a surface of a substrate by sputtering, without an undercoat layer. Hereinafter, this sputtering method is referred to as a direct sputtering method. The resin product can have a delicate and fine design at the surface thereof because concave portions on the surface of the substrate are not filled with a part of the thick undercoat layer. Thus, the resin product including the metal film formed by the direct sputtering method on the surface of the substrate has an excellent design, which cannot be obtained in the conventional products including the undercoat layer. It is expected that the resin product be used in more fields by taking advantage of this merit.

Generally, the resin product including the metal film formed directly on the surface of the substrate by sputtering is manufactured as follows.

In the manufacture of such a resin product, a workspace for manufacturing the resin product consists of three divided areas, i.e., a molding area, a metal film deposition area, and a coating film formation area. In the molding area, a molding apparatus for molding a substrate, such as an injection molding apparatus, is provided. In the metal film deposition area, a metal film deposition apparatus, such as a sputtering apparatus, is provided for forming a metal film on a surface of the substrate formed by the molding apparatus. In the coating film formation area, a paint and dry booth is provided for forming a coating film on the metal film by applying and drying a predetermined paint or coating material on the surface of the substrate. Further, a transfer line such as a conveyor is provided between the molding area, the metal film deposition area, and the coating film formation area.

Initially, a substrate is formed by the molding apparatus and removed from the molding apparatus by an automatic removal machine. Then, the substrate is transferred from the molding area to the metal film deposition area by the transfer line. The substrate transferred to the metal film deposition area is manually stocked temporarily at a shelf provided in the metal film deposition area such that the number of the substrate does not exceed the maximum transfer capacity of the transfer line. When the number of stocked substrates reaches a predetermined number, these substrates are manually moved into a sputtering apparatus. Then, metal films are formed on surfaces of the substrates in the sputtering apparatus. Thus, a plurality of intermediate products each having the metal film directly formed on the surface of the substrate are manufactured at once. Next, the plurality of intermediate products are manually removed from the sputtering apparatus and stocked temporarily at a shelf. After that, the intermediate products are transferred in sequence to the coating film formation area. When the number of intermediate products transferred to the coating film formation area reaches a predetermined number, each of the intermediate products is manually fixed to a coating jig for retaining the intermediate product. Then, the intermediate product fixed to the coating jig is transferred to a paint booth and is coated and dried therein. Thus, a coating film is formed on the metal film of the intermediate product and the intended resin product is produced. After that, the resin product is manually removed from the paint booth and detached from the coating jig, and then manually carried to an inspection room by using a cart, for example. In the inspection room, good quality products are chosen by visual check, for example. As a result, the resin products of good quality are obtained.

As described above, the conventional manufacturing system of the resin product including the substrate and the laminate of the metal film and the coating film formed on the surface of the substrate requires many manual works in the metal film deposition area and the coating film formation area. Thus, the manufacture of resin production requires a lot of labor cost, which prevents the reduction in the production cost of the resin product. Further, in the metal film deposition area and the coating film formation area, the substrates and the intermediate products are stocked as intermediate stocks until the number of the intermediate stocks reaches a predetermined number. As a result, in addition to the equipment for controlling the temperature, humidity and the cleanness level of the transfer line of the substrates and the intermediate products, a lot of equipment for controlling those of the storage of the intermediate stocks is required. Thus, the production cost of the resin product is increased.

Further, for example, the following problems are arisen in the manufacture of various kinds of resin products using a plurality of molding apparatuses which require a different molding cycle, a different metal film deposition cycle, and a different coating film forming cycle due to various shapes and sizes of the resin products, in accordance with the above-described conventional process that requires a lot of manual works.

Specifically, in the manufacture of plural kinds of resin products, the operating time of each of the molding apparatuses, the metal film deposition apparatus, and the coating film forming apparatus varies depending on the kind of substrates, intermediate products, or resin products, which are to be molded or formed. Further, even in the manufacture of the substrates, the intermediate products, or the resin products of the same kind, the operating time of each of the apparatuses is not exactly the same, but slightly varies. Thus, the time required between the start of the molding operation of the substrate in the molding area and the arrival of the substrate at the metal film deposition area or the arrival of the intermediate product at the coating film formation area is varied. In the manufacture of the plural kinds of resin products in accordance with the conventional process, in order to deal with the variation of time, the operation rate of each of the apparatuses and the number of workers in each area should be adjusted, inevitably resulting in insufficient and complicated manual works. Further, in order to eliminate a difference in processing power of apparatus in each area, intermediate products are necessary. Thus, there is a high possibility that the productivity and the cost efficiency in the manufacture of plural kinds of the resin products in accordance with the conventional process are poorer than those in the manufacture of only one kind of the resin product.

### SUMMARY OF THE INVENTION

The present invention has been made in the light of the situations described above, and an object of the invention is to provide a novel structure of a manufacturing system of a resin product including a substrate formed of a resin molded article, a laminate of a metal film and a coating film formed on the substrate, characterized in that the manual works and intermediate products in the manufacturing processes are eliminated, regardless of the number of kinds of resin products to be manufactured, enabling the manufacture of the intended resin product at a lower cost with higher efficiency.

To achieve the aforementioned object, or to solve the problems understood from description throughout the present specification and drawings, the present invention may be preferably embodied according to various aspects which will be described below. Each aspect described below may be employed in any combination. It is to be understood that the aspects and technical features of the present invention are not limited to those described below, and can be recognized based on the inventive concept disclosed in the whole specification and drawings.

<1> A resin product manufacturing system comprising: (a) at least one molding apparatus for forming substrates made of resin molded articles; (b) a metal film deposition apparatus for forming a metal film on a surface of each of the substrates by sputtering to obtain intermediate products; (c) a coating film forming apparatus for forming a coating film on the metal film of each of the intermediate products to obtain resin products; (d) a first transfer apparatus including a plurality of substrate supporting stations each capable of supporting one of the substrates and each provided with a substrate transfer mechanism for transferring the substrates in sequence, the first transfer apparatus being arranged such that the substrate transfer mechanism of one of adjacent two substrate supporting stations that is positioned at the upstream side starts to transfer one of the substrates after the substrate transfer mechanism of the other one of adjacent two substrate supporting stations that is positioned at the downstream side completes the transfer of one of the substrates; (e) a second transfer apparatus including a plurality of intermediate product supporting stations each capable of supporting one of the intermediate products and each provided with an intermediate product transfer mechanism for transferring the intermediate products in sequence, the second transfer apparatus being arranged such that the intermediate product transfer mechanism of one of adjacent two intermediate product supporting stations that is positioned at the upstream side starts to transfer one of the intermediate products after the intermediate product transfer mechanism of the other one of adjacent two intermediate product supporting stations that is positioned at the downstream side completes the transfer of one of the intermediate products; (f) a substrate removal apparatus for removing the substrates from the at least one molding apparatus and allowing each of the substrates to be supported by a first substrate supporting station, which is one of the plurality of substrate supporting stations that is positioned at a predetermined place; (g) a substrate carrying machine for carrying the substrates each supported by a second substrate supporting station into the metal film deposition apparatus, the second substrate supporting station being one of the plurality of substrate supporting stations that is positioned at the downstream side of the first substrate supporting station in the transfer direction of the substrates; (h) an intermediate product removal machine for removing the intermediate products from the metal film deposition apparatus and allowing each of the removed intermediate products to be supported by a first intermediate product supporting station, which is one of the plurality of intermediate product supporting stations that is positioned at a predetermined position; (i) an intermediate product carrying machine for carrying the intermediate products each supported by a second intermediate product supporting station into the coating film forming apparatus, the second intermediate product supporting station being one of the plurality of intermediate product supporting stations that is positioned at the downstream side of the first intermediate product supporting station in the transfer direction of the intermediate products; (j) a first control unit for controlling the substrate removal apparatus such that the substrate removal apparatus starts its operation upon completion of the transfer of one of the substrates by the substrate transfer mechanism of the first substrate supporting station; (k) a second control unit for controlling each of the intermediate product removal apparatus, the substrate carrying machine, and the metal film deposition apparatus, such that the intermediate product removal apparatus starts its operation upon completion of the transfer of one of the intermediate products by the intermediate product transfer mechanism of the first intermediate product supporting station, and such that the substrate carrying machine and the metal film deposition apparatus are operated in conjunction with the operation of the intermediate product removal apparatus; and (I) a third control unit for controlling the intermediate product carrying machine such that the operation of the intermediate product carrying machine is suspended when the operation of the coating film forming apparatus is suspended.

<2> The resin product manufacturing system according to the above aspect <1>, wherein the at least one molding apparatus comprises a plurality of molding apparatuses, and each of the plurality of molding apparatuses arranged to form a different kind of substrate having a different shape, whereby plural kinds of intermediate products having different shapes are obtained after the formation of the metal film on the surface of each of plural kinds of substrates.

<3> The resin product manufacturing system according to the above aspect <2>, further comprising: (m) a plurality of first retaining jigs each transferred by the first transfer apparatus while retaining each of the substrates; (n) plural kinds of first retaining portions each capable of retaining each of the substrates, each of the first retaining portions being provided on the plurality of first retaining jigs and having a different shape depending on the kind of substrate to be retained; (o) a first jig stocker arranged to store the plurality of first retaining jigs therein and remove any one of the plurality of first retaining jigs therefrom to be transferred onto one of the plurality of substrate supporting stations of the first transfer apparatus; and (p) a first decision unit for determining the removal order of the plurality of first retaining jigs from the first jig stocker, based on the molding order of the plural kinds of substrates, such that the plurality of first retaining jigs provided with the first retaining portions are removed in sequence from the first jig stocker in the same order as the molding order of the plural kinds of substrates.

<4> The resin product manufacturing system according the above aspect <3>, wherein, every time the plural kinds of substrates are formed by the plurality of molding apparatuses, the plurality of molding apparatuses output a plural kinds of substrate molding signals corresponding to the kinds of substrates formed, and based on the plural kinds of substrate molding signals, the first decision unit determines the kind of first retaining jig to be removed from the first jig stocker.

<5> The resin product manufacturing system according the above aspect <3> or <4>, wherein the first retaining portion is rotatably provided on a body of each of the plurality of first retaining jigs and a rotation mechanism for rotating the first retaining portion is provided in the metal film deposition apparatus, whereby the metal film is formed on each of the substrates in the metal film deposition apparatus while each of the substrates is rotated together with the first retaining portion rotated by the rotation mechanism, and wherein a positioning mechanism is provided for positioning the first retaining portion that retains each of the intermediate products including the metal film at a reference rotation position.

<6> The resin product manufacturing system according to any one of the above aspects <2> to <5>, further comprising: a discrimination unit for discriminating the kind of substrate to be transferred into the metal film deposition apparatus by the substrate transfer apparatus and outputting plural kinds of discrimination signals corresponding to the kind of substrate to be transferred; and a second decision unit for selecting and determining a deposition condition depending on the kind of substrate to be transferred into the metal film deposition apparatus among plural kinds of deposition conditions of the metal film in the metal film deposition apparatus, based on the discrimination signals outputted from the discrimination unit, whereby the metal film is formed under the deposition condition that is suitable to the kind of substrate transferred into the metal film deposition apparatus.

<7> The resin product manufacturing system according to any one of the above aspects <2> to <6>, further comprising: (q) a plurality of second retaining jigs each transferred into the coating film forming apparatus while retaining each of the intermediate products; (r) plural kinds of second retaining portions each capable of retaining each of the intermediate products, each of the plurality of second retaining portions being provided on the plurality of second retaining jigs and having a different shape depending on the kind of substrate to be retained; (s) a second jig stocker arranged to store the plurality of second retaining jigs therein and remove any one of the plurality of second retaining jigs therefrom to be transferred into the coating film forming apparatus; and (t) a third decision unit for determining the removal order of the plurality of second retaining jigs from the second jig stocker, based on the production order of the plural kinds of the intermediate products, such that the plurality of second retaining jigs each including the second retaining portion are removed in sequence from the second jig stocker in the same order as the production order of the plural kinds of the intermediate products.

The resin product manufacturing system in accordance with the present invention can advantageously eliminate the manual works and intermediate stocks in the manufacturing process during the manufacture of the resin product including a substrate formed of a resin molded article, a laminate of a metal film, and a coating film formed on the substrate, regardless of the number of kinds of the intended resin products. As a result, labor cost can be effectively reduced, and a lot of equipments and a large space for storing the intermediate stocks can be advantageously eliminated. Consequently, the intended resin products can be effectively manufactured at a low cost.

### BRIEF DESCRIPTION OF THE DRAWINGS

The above and other objects, features, advantages and technical and industrial significance of the present invention will be better understood by reading the following detailed description of a preferred embodiment of the invention, when considered in connection with the accompanying drawings, in which:
Fig. 1 is a view schematically showing a resin product manufacturing system in accordance with an embodiment of the present invention;
Fig. 2 is a plan view showing a transfer line included in the manufacturing system illustrated in Fig. 1;
Fig. 3 is an explanation view viewed from a direction of arrow A in Fig. 2, including a cutaway section;
Fig. 4 is a cross sectional view of a first substrate-retaining device that moves on the transfer line shown in Fig. 2 and Fig. 3 while retaining a substrate or an intermediate product;
Fig. 5 is a plan view of the first substrate-retaining device shown in Fig. 4;
Fig. 6 is a cross sectional view of a second substrate-retaining device that moves on the transfer line shown in Fig. 2 and Fig. 3 while retaining a substrate or an intermediate product;
Fig. 7 is a plan view of the second substrate-retaining device shown in Fig. 6;
Fig. 8 is a back side view of the first substrate-retaining device shown in Fig. 4;
Fig. 9 is a side view showing a first storage unit included in the manufacturing system shown in Fig. 1, including a cutaway section;
Fig. 10 is a view showing a metal film deposition apparatus included in the manufacturing system shown in Fig. 1;
Fig. 11 is a view showing a circulation device of a coating film forming apparatus included in the manufacturing system shown in Fig .1, and a first intermediate product retaining device and a second intermediate product retaining device that are circulated in the coating film forming apparatus by the circulation device;
Fig. 12 is an explanation view viewed from a direction of arrow B in Fig. 11; and
Fig. 13 is a side view showing a third storage unit included in the manufacturing system shown in Fig. 1, including a cutaway section.

### DETAILED DESCRIPTION OF THE INVENTION

To further clarify the present invention, there will be described in detail embodiments of the present invention with reference to the accompanying drawings.

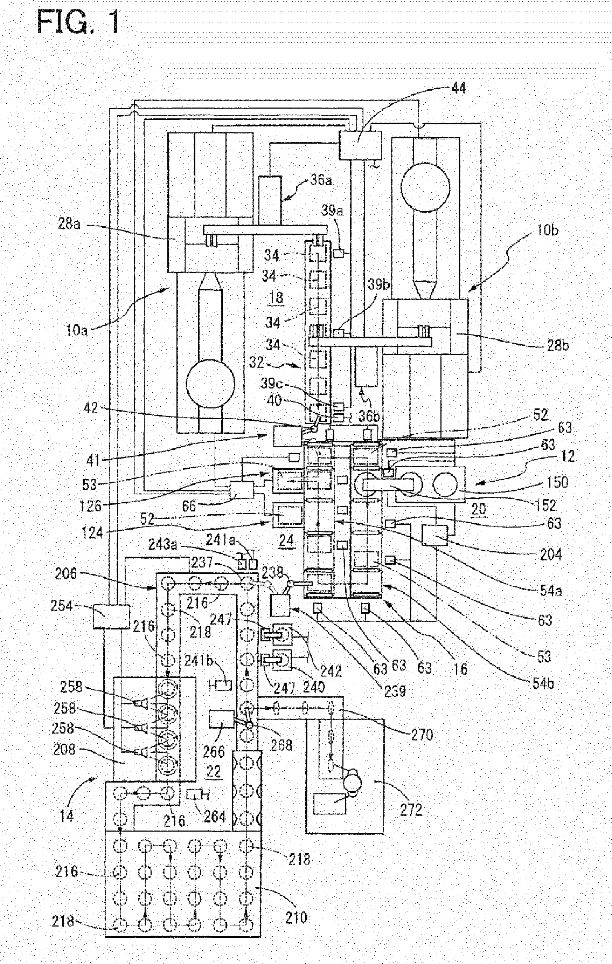

Initially, Fig. 1 is a plan view schematically showing a resin product manufacturing system having a structure in accordance with one embodiment of the present invention. As apparent from Fig. 1, the manufacturing system of the present embodiment includes: a first injection molding apparatus 10a and a second injection molding apparatus 10b each for forming a substrate (not shown) made of a resin molded article; a metal film deposition apparatus 12 for forming a metal film on a surface of the substrate formed by the first and second injection molding apparatus 10a, 10b to obtain an intermediate product (not shown); a coating film forming apparatus 14 for forming a coating film on the metal film of the intermediate product formed by the metal film deposition apparatus 12 to obtain an intended resin product (not shown); and a transfer line 16 for transferring the substrate formed by the first and second injection molding apparatuses 10a, 10b and the intermediate product formed by the metal film deposition apparatus 12. As shown in Fig. 1, a molding area 18 is where the first and second injection molding apparatuses 10a, 10b are provided, a metal film deposition area 20 is where the metal film deposition apparatus 12 is provided, a coating film formation area 22 is where the coating film forming apparatus 14 is provided, and a transfer area 24 is where the transfer line 16 is provided.

More specifically described, each of the first injection molding apparatus 10a and the second injection molding apparatus 10b provided in the molding area 18 has the conventionally known structure and is arranged to form a substrate formed of a resin molded article that has a different shape. Hereinafter, the substrate to be formed by the first injection molding apparatus 10a is referred to as a substrate α and the substrate to be formed by the second injection molding apparatus 10b is referred to as a substrate β.

Further, a transfer conveyor 32 is provided in the molding area 18 to transfer two kinds of substrates α and β, which are formed by the first and second injection molding apparatuses 10a, 10b. The transfer conveyor 32 has a conventional structure and consisting of a belt conveyor in the present embodiment. On a transfer belt of the transfer conveyor 32, supporting jigs 34 (shown in Fig. 1 by the two-dot chain line) each supporting the substrate α or the substrate β are fixed with a predetermined distance therebetween.

Furthermore, a first substrate releasing device 36a and a second substrate releasing device 36b are provided in the molding area 18 to automatically release the substrate α and the substrate β from the first injection molding apparatus 10a and the second injection molding apparatus 10b. The first and second substrate releasing devices 36a, 36b release the substrate α and the substrate β, which are subjected to gate cutting by an automated gate cutting machine (not shown), from mold units 28a, 28b and allow them to be supported by the supporting jigs 34 on the transfer conveyor 32.

In the present embodiment, the substrate α is supported by one of the supporting jigs 34 positioned at a start point which is the upstream end in the substrate transfer direction of the transfer conveyor 32. The substrate β is supported by one of the supporting jigs 34 positioned at the middle in the substrate transfer direction of the transfer conveyor 32. In the transfer conveyor 32, the supporting jigs 34 are positioned so as to be spaced apart from each other such that when one supporting jig 34 is positioned at the start point, another supporting jig 34 is positioned at the middle point and further another supporting jig 34 is positioned at a terminal point, which is the downstream end in the substrate transfer direction of the transfer conveyor 32.

In the molding area 18, substrate detector sensors 39a, 39b, 39c are provided at three positions corresponding to the start point, the middle point, and the terminal point of the transfer conveyor 32, and a supporting jig detector sensor 40 is also provided at a position corresponding to the terminal point. Thus, it is always monitored whether there is the substrate α or the substrate β at the three positions, i.e., the start point, the middle point, and the terminal point of the transfer conveyor 32, by the substrate detector sensors 39a, 39b, 39c, and it is always monitored whether there is the supporting jig 34 at the terminal point on the transfer conveyor 32 by the substrate detector sensor 40. The sensors having conventionally known structures such as a photoelectric sensor, a laser sensor, a non-contact sensor, and a sensor camera may be used as the substrate detector sensors 39a, 39b, 39c and the supporting jig detector sensor 40.

In the molding area 18, a transfer device 41 is also provided. The transfer device 41 is arranged to transfer the substrate α or the substrate β by removing the substrate α or β from the supporting jig 34 by using a robot arm 42, which has a conventionally known structure, and allowing the substrate α or β to be retained by a first substrate-retaining device 52 or a second substrate-retaining device 53, which is a first retaining jig that will be described later.

Further, in the molding area 18, a control unit for molding area 44 is provided. The control unit for molding area 44 controls the operation of each apparatus by using the signals sent from the apparatus provided in the molding area.

More specifically described, based on the signal input into the control unit for molding area 44 from the supporting jig detector sensor 40, the control unit for molding area 44 recognizes that the supporting jig 34 is positioned at the terminal point of the transfer conveyor 32. Further, at the same time, the control unit for molding area 44 also recognizes that the supporting jig 34 is positioned at each of the start point and the middle point. Further, at that time, if the signal is not input into the control unit for molding area 44 from the substrate detector sensor 39a, 39b, the control unit for molding area 44 determines that the substrate α and the substrate β are not supported by the supporting jigs 34 positioned at the start point and the middle point of the transfer conveyor 32. In that case, the control unit for molding area 44 allows the first and second substrate releasing devices 36a, 36b to be operated. Each time one operation of the first and second substrate releasing devices 36a, 36b is completed, a signal for the completion of operation is input into the control unit for molding area 44 from the first and second substrate releasing devices 36a, 36b.

In the control unit for molding area 44, based on the order of the signal for the completion of operation inputted from the first and second substrate releasing devices 36a, 36b, the formation order of the substrate α and the substrate β from the beginning of the operation can be recognized. At this time, a substrate molding order detector signal which is obtained by converting the molding order of the substrate α or substrate β is output from the control unit for molding area 44 to a control unit for transfer area 66, which will be described later. As apparent from this, in the present embodiment, the signal for the completion of operation that is outputted from the first and second substrate releasing devices 36a, 36b constitutes a substrate molding signal, which is output from each of the molding apparatuses.

As shown in Fig. 1, the transfer line 16 provided in the transfer area 24 is surrounded by the molding area 18, the metal film deposition area 20, and the coating film formation area 22. The transfer line 16 includes a substrate transfer section that extends from the position close to the molding area 18 to the position close to the metal film deposition area 20, an intermediate product transfer section that extends from the position close to the metal film deposition area 20 to the position close to the coating film formation area 22, and a retaining jig transfer section that extends from the position close to the coating film formation area 22 to the position close to the molding area 18.

Therefore, the transfer line 16 allows the first substrate-retaining device 52 retaining the substrate α and the second substrate-retaining device 53 retaining the substrate β, which are moved onto the transfer line 16 from the transfer conveyor 32, to be circulated in the transfer area 24 between the positions close to the molding area 18, the metal film deposition area 20, and the coating film formation area 22. The first substrate-retaining device 52 and the second substrate-retaining device 53 are shown in Fig. 1 by the two-dot chain line.

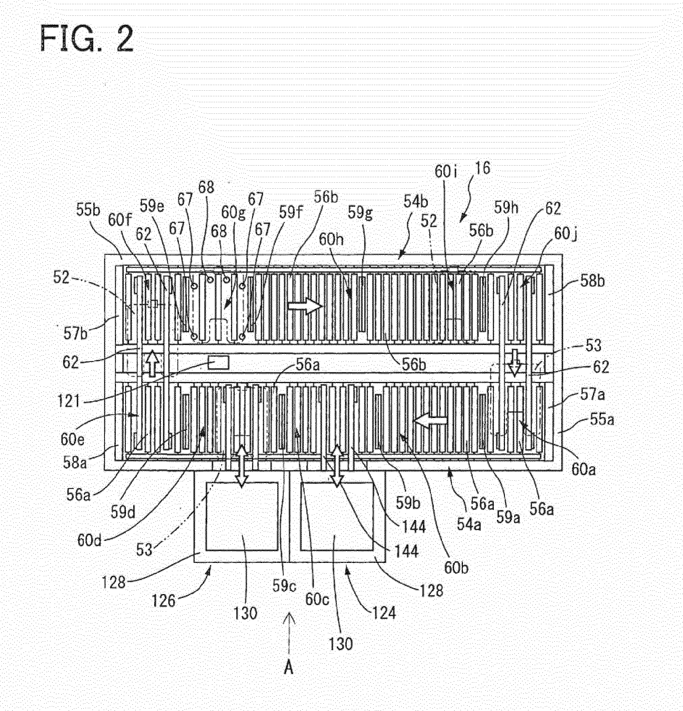

As shown in Fig. 2, the transfer line 16 includes a first roller conveyor 54a and a second roller conveyor 54b that extend parallel to each other. The first and second roller conveyors 54a, 54b have the same structure and each includes a mount 55a, 55b and driving rollers 56a, 56b fixed to the mount 55a, 55b. A driving motor (not shown) rotationally drive the driving rollers 56a of the first roller conveyor 54a and the driving rollers 56b of the second roller conveyor 54b so as to rotate in opposite directions. As a result, the transfer direction of the first and second substrate-retaining devices 52, 53 by the first roller conveyor 54a and the transfer direction of the first and second substrate-retaining devices 52, 53 by the second roller conveyor 54b are opposite to each other.

The first roller conveyor 54a includes a start side supporting station 60a, a first middle supporting station 60b, a second middle supporting station 60c, a third middle supporting station 60d, and a terminal side supporting station 60e, which are arrayed in series with each other. Further, the second roller conveyor 54b includes a start side supporting station 60f, a first middle supporting station 60g, a second middle supporting station 60h, a third middle supporting station 60i, and a terminal side supporting station 60j, which are arrayed in series with each other. Each of the supporting stations 60a to 60e and 60f to 60j of the first and second roller conveyors 54a, 54b is provided with the driving rollers 56a, 56b, thereby supporting one of the first substrate-retaining device 52 and the second substrate-retaining device 53.

At upper stream of the start side supporting stations 60a, 60f in the transfer direction of the first and second substrate-retaining devices 52, 53, start side stoppers 57a, 57b are vertically provided, and at down stream of the terminal side supporting stations 60e, 60j, terminal side stoppers 58a, 58b are provided. Between the adjacent supporting stations 60a to 60e and 60f to 60j of the first and second roller conveyors 54a, 54b, first middle stoppers 59a, 59e, second middle stoppers 59b, 59f, third middle stoppers 59c, 59g, and fourth middle stoppers 59d, 59h are respectively provided from the start point to the terminal point.

As shown in Fig. 1 and Fig. 2, in the transfer line 16, a section between the terminal side supporting station 60e of the first roller conveyor 54a and the first middle supporting station 60g of the second roller conveyor 54b is defined as the substrate transfer section, which is a first transfer apparatus extending between the position close to the molding area 18 and the position close to the metal film deposition area 20. Each of the terminal side supporting station 60e, the start side supporting station 60f, and the first middle supporting station 60g constitutes a substrate supporting station. Further, a section between the first middle supporting station 60g of the second roller conveyor 54b and the start side supporting station 60a of the first roller conveyor 54a is defined as the intermediate product transfer section, which is a second transfer apparatus extending between the position close to the metal film deposition area 20 and the position close to the coating film formation area 22. Each of the first, second, third middle and terminal side supporting stations 60g, 60h, 60i, 60j, 60a constitutes an intermediate product supporting station. Further, a section between the start side supporting station 60a and the terminal side supporting station 60e of the first roller conveyor 54a is defined as the retaining jig transfer section extending between the position close to the coating film formation area 22 and the position close to the molding area 18.

Each of the first to fourth middle stoppers 59a to 59h of the first and second roller conveyors 54a, 54b can be projected and retracted between a position higher than the upper surface (the surface supporting the first and second substrate-retaining devices 52, 53) of each of the supporting stations 60a to 60j by a predetermined height and a position flush with the upper surface. For example, the first to fourth middle stoppers 59a to 59h can be easily projected and retracted by the rotational driving force of the electric motor (not shown) provided at each of the mounts 55a, 55b. The rotational driving force is transmitted to the first to fourth middle stoppers 59a to 59h as a vertical driving force by a gear mechanism (not shown), which is a combination of a pinion and a rack.

In the first and second roller conveyors 54a, 54b, when the first to fourth middle stoppers 59a to 59h are retracted, the rotation of the rollers 54a, 54b provided at the supporting stations 60a to 60d, 60f to 60i transfers the first substrate-retaining device 52 and the second substrate-retaining device 53, which are supported by the start side and first to third middle stations 60a to 60d, 60f to 60i, to the terminal side supporting station 60e, 60j side. When the first to fourth middle stoppers 59a to 59h are projected, even though the rollers 54a, 54b are constantly rotated, the abutting contact with the first to fourth middle stoppers 59a to 59h prevents the first and second substrate-retaining devices 52, 53, which are supported by the start side and first to third middle stations 60a to 60d, 60f to 60i, from being transferred to the terminal side supporting station 60e, 60j side.

That is, in the first and second roller conveyors 54a, 54b, the first and second substrate-retaining device 52, 53 that are supported by the start side and first to third middle stations 60a to 60d, 60f to 60i are transferred (sent) in sequence to the next supporting station 60 positioned at the terminal side supporting stations 60e, 60j side in response to the projection and the retraction of the first to fourth middle stoppers 59a to 59h.

The first substrate-retaining device 52 and the second substrate-retaining device 53 transferred to the terminal side supporting station 60e, 60j side are kept to be supported on the terminal side supporting station 60e, 60j without falling off from the first and second roller conveyors 54a, 54b due to the abutting contact with the terminal side supporting stations 60e, 60j.

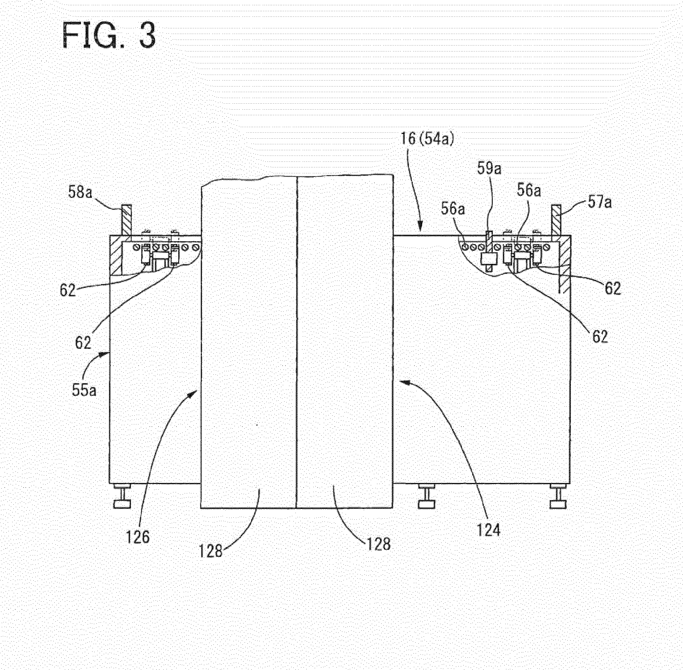

As shown in Fig. 2 and Fig. 3, two carrying belts 62, 62 are provided so as to extend horizontally between the terminal side supporting station 60e of the first roller conveyor 54a and the start side supporting station 60f of the second roller conveyor 54b, and between the terminal side supporting station 60j of the second roller conveyor 54b and the start side supporting station 60a of the first roller conveyor 54a.

The two carrying belts 62, 62 are traveled at a constant speed based on a drive of the driving motor (not shown). The carrying belts 62, 62 travel in the direction that enables an object on the carrying belts 62, 62 to be transferred from the terminal side supporting stations 60e, 60j side to the start side supporting stations 60f, 60a side.

The two carrying belts 62, 62 are simultaneously moved upward and downward between the position higher (indicated by the two-dot chain line in Fig. 3) and the position lower (indicated by the solid line in Fig. 3) than the upper surface of the terminal side and start side supporting stations 60e, 60j, 60f, 60a (the upper surface of the transfer line 16 supporting the first and second substrate-retaining devices 52, 53).

The rotational drive of the two carrying belts 62, 62 positioned higher than the upper surface of the transfer line 16 transfer the first substrate-retaining device 52 or the second substrate retaining device 53 supported by the terminal side supporting station 60e, 60j to the start side supporting station 60f, 60a while being supported by the two carrying belts 62, 62. Upon completion of the transfer of the first or second substrate-retaining device 52, 53, the carrying belts 62, 62 are retracted into the upper surface of the transfer line 16, whereby the first or second substrate-retaining device 52, 53 is supported by the start side supporting station 60f, 60a.

As described above, in the transfer line 16, the driving rollers 56a, 56b, which are provided on the first roller conveyor 54a and second roller conveyor 54b, the carrying belts 62, 62, the start side and terminal side stoppers 57a, 57b, 58a, 58b, and the middle stoppers 59a to 59h work in cooperation to transfer the first substrate-retaining device 52 and the second substrate-retaining device 53 one by one through the supporting stations 60a to 60e of the first roller conveyor 54a and the supporting stations 60f to 60j of the second roller conveyor 54b from the start point to the terminal point of the first roller conveyor 54a and from the start point to the terminal point of the second roller conveyor 54b, which means that the first and second substrate-retaining devices 52, 53 are circulated. As apparent from this, in the present embodiment, the driving rollers 56a, 56b, the carrying belts 62, 62, the start side and terminal side stoppers 57a, 57b, 58a, 58b, and the middle stoppers 59a to 59h constitute a substrate transfer mechanism and an intermediate product transfer mechanism.

As shown in Fig.1, the transfer device 41 that transfers the substrate α or the substrate β from the transfer conveyor 32 in the molding area 18 onto the transfer line 16 is provided between the terminal point of the transfer conveyor 32 and the terminal side supporting station 60e of the first roller conveyor 54a.

The substrate α or the substrate β transferred to the terminal point of the transfer conveyor 32 is allowed to be retained by the first or second substrate-retaining device 52, 53 supported on the terminal side supporting station 60e of the first roller conveyor 54a, by the robot arm 42 of the transfer device 41. Then, the substrate α or the substrate β is transferred in sequence on the transfer line 16 with the first or second substrate-retaining device 52, 53 in the same direction as the transfer direction of the first and second substrate-retaining devices 52, 53. As apparent from this, in the present embodiment, the first or second substrate releasing device 36a, 36b, which is provided in the molding area 18, the transfer conveyor 32, and the transfer device 41, constitute a substrate removal apparatus. Further, the terminal side supporting station 60e of the first roller conveyor 54a constitutes a first substrate supporting station.

Further, as apparent from Fig. 1, around the transfer line 16 in the transfer area 24, a substrate retaining device detector sensor 63 consisting of a photoelectric sensor or an infrared ray sensor, for example, is provided for each of the supporting stations 60a to 60j. Further, the control unit for transfer area 66 is provided in the transfer area 24 to receive a substrate retaining device detector signal sent from the substrate retaining device detector sensor 63.

When the first substrate-retaining device 52 or the second substrate-retaining device 53 is supported on the start side supporting station 60a, 60f and the first to third middle supporting stations 60b to 60d, 60g to 60i of the first and second roller conveyors 54a, 54b, the substrate retaining device detector sensor 63 and the control unit for transfer area 66 determine whether the first or second substrate-retaining device 52, 53 is supported on the next supporting station 60 adjacent to the supporting station 60 retaining the first or second substrate-retaining device 52, 53, at the downstream side. When the control unit for transfer area 66 determines that the first or second substrate-retaining device 52, 53 is not supported, the middle stopper 59 positioned between the supporting station 60 supporting the first or second substrate-retaining device 52, 53 and the next supporting station 60 is retracted under the control of the control unit for transfer area 66. Then, the first or second substrate-retaining device 52, 53 is transferred from the supporting station 60 onto the next supporting station 60.

When the first substrate-retaining device 52 or the second substrate-retaining device 53 is supported on the terminal side supporting station 60e, 60j of the first and second roller conveyors 54a, 54b, the substrate retaining device detector sensor 63 and the control unit for transfer area 66 determine whether or not the first or second substrate-retaining device 52, 53 is supported on the start side supporting station 60f of the second roller conveyor 54b or the start side supporting station 60a of the first roller conveyor 54a. When the control unit for transfer area 66 determines that the first or second substrate-retaining device 52, 53 is not supported, the two carrying belts 62, 62 provided between the terminal side supporting station 60e, 60j and the start side supporting station 60f, 60a are moved up and rotationally driven to transfer the first or second substrate-retaining device 52, 53 on the terminal side supporting station 60e, 60j to the start side supporting station 60f, 60a.

When the substrate retaining device detector sensor 63 and the control unit for transfer area 66 determine that the supporting stations 60 that do not support any first or second substrate-retaining device 52, 53 are present between one supporting station 60 supporting the first or second substrate-retaining device 52, 53 and another supporting station 60 supporting the first or second substrate-retaining device 52, 53 at the downstream side in the transfer direction of the first or second substrate-retaining device 52, 53, all of the middle stoppers 59 positioned between the supporting stations 60, 60 supporting the first or second substrate-retaining device 52, 53 are retracted at once, or all of the carrying belts 62 positioned between the supporting stations 60, 60 are rotationally driven and moved up or down.

This arrangement allows the first or second substrate-retaining device 52, 53 supported by one supporting station 60 positioned at the upstream side to pass through the supporting stations 60 to the last supporting station 60 that is positioned before the another supporting station 60 (upstream side), without being stopped at each of the supporting stations 60 positioned between the one supporting station 60 and another supporting station 60 that is positioned at the downstream side and supports the first or second substrate-retaining device 52, 53.

When the substrate retaining device detector sensor 63 and the control unit for transfer area 66 determine that the first or second substrate-retaining device 52, 53 is supported on the terminal side supporting station 60e of the first and second roller conveyors 54a, a transfer enable signal is inputted to the control unit for molding area 44 from the control unit for transfer area 66. Based on the transfer enable signal inputted to the control unit for molding area 44, the transfer device 41 is operated under the control of the control unit for molding area 44.

Accordingly, only when the first or second substrate-retaining device 52, 53 is supported on the terminal side supporting station 60e, the substrate α or the substrate β supported by the supporting jig 34 positioned at the terminal point of the transfer conveyor 32 in the molding area 18 is transferred to the terminal side supporting station 60e side and supported by the first or second substrate-retaining device 52, 53 on the terminal side supporting station 60e.

In the case where the transfer device 41 is continuously operated to allow the substrate α or the substrate β, which is transferred to the terminal point of the transfer conveyor 32, to be retained on the first or second substrate-retaining device 52, 53 on the terminal side supporting station 60e, the transfer device 41 is controlled indirectly or directly by the control unit for transfer area 66 and the control unit for molding area 44 such that the substrate α or the substrate β is transferred by the transfer device 41 after the first or second substrate-retaining device 52, 53 on the terminal side supporting station 60e is transferred to the start side supporting station 60f of the second roller conveyor 54b.

Specifically, the first or second substrate-retaining device 52, 53 on the terminal side supporting station 60e is transferred to the start side supporting station 60f of the second roller conveyor 54b, together with the substrate α or the substrate β retained thereon. Upon completion of the transfer, a signal for the completion of transfer is output to the control unit for molding area 44 from the control unit for transfer area 66. Based on the signal, the transfer device 41 is operated under the control of the control unit for molding area 44 to transfer the next substrate α or β by the transfer device 41. As apparent from this, in the present embodiment, the control unit for molding area 44 constitutes a first control unit.

Although the substrate α or the substrate β is positioned on the terminal point of the transfer conveyor 32 when the first or second substrate-retaining device 52, 53 is transferred to the terminal side supporting station 60e, the transfer device 41 is not necessarily operated to allow the substrate α or β to be retained on the first or second substrate-retaining device 52, 53. In some cases, the first or second substrate-retaining device 52, 53 is transferred to the start side supporting station 60f of the second roller conveyor 54b without retaining the substrate α or the substrate β. As will be described later, when there is a need to retain the intermediate product, which is removed from the metal film deposition apparatus 12, on the first or second substrate-retaining device 52, 53, the first or second substrate-retaining device 52, 53 that does not retain the substrate α or β is transferred from the start side supporting station 60f.

As shown in Fig. 2, on the first middle supporting station 60g of the second roller conveyor 54b, four lifting pins 67, 67, 67, 67 and two thrust pins 68, 68 are provided. End portions of the lifting pins 67 and the thrust pins 68 are adapted to be automatically projected from or retracted into the upper surface of the first middle supporting station 60g. The projected stroke of the thrust pin 68 is bigger than that of the lifting pin 67. The lifting pins 67 and the thrust pins 68 are projected when the substrate retaining device detector sensor 63 detects that the first substrate-retaining device 52 or the second substrate-retaining device 53 is retained on the first middle supporting station 60g of the second roller conveyor 54b.

Accordingly, the entire of the first substrate-retaining device 52 or the second substrate-retaining device 53 retained on the first middle supporting station 60g is lifted by the four lifting pins 67, 67, 67, 67, and then only a casing 94, which will be described later, of each of the first and second substrate-retaining devices 52, 53 is further lifted by the two thrust pins 68, 68.

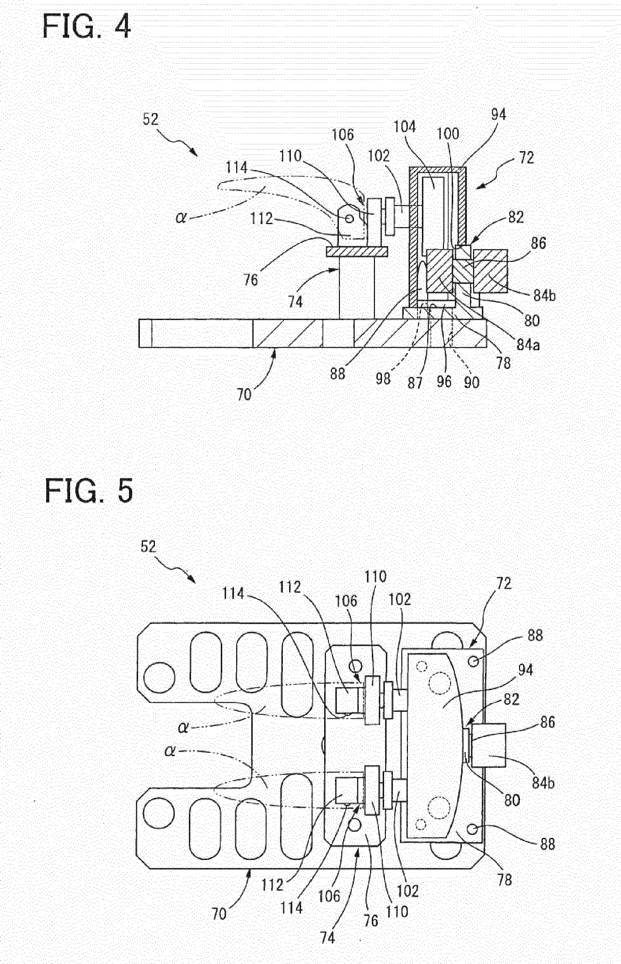

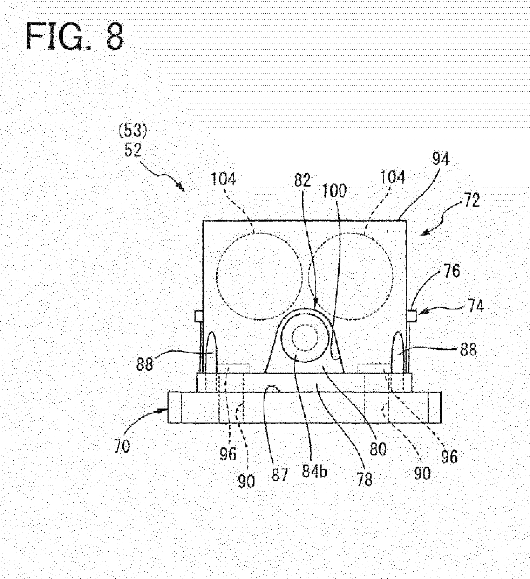

The following is an explanation of the structure of the first substrate-retaining device 52 and the second substrate-retaining device 53. As shown in Fig. 4 and Fig. 8, the first substrate-retaining device 52 and the second substrate-retaining device 53 each includes a pallet 70 and a substrate-retaining jig 72 and have basically the same structure except for the structure of the portion where the substrate α or the substrate β is retained. The first substrate-retaining device 52 and the second substrate-retaining device 53 have the same back view. Thus, only the back view of the first substrate-retaining device 52 will be shown in Fig. 8, and the explanation of the back view of the second substrate-retaining device 53 is dispensed with.

The pallet 70 of the first substrate-retaining device 52 and the second substrate-retaining device 53 has a longitudinal flat plate shape as a whole. At the longitudinal middle portion of the pallet, a table 74 having an upper surface, which is a horizontal surface 76, is fixed.

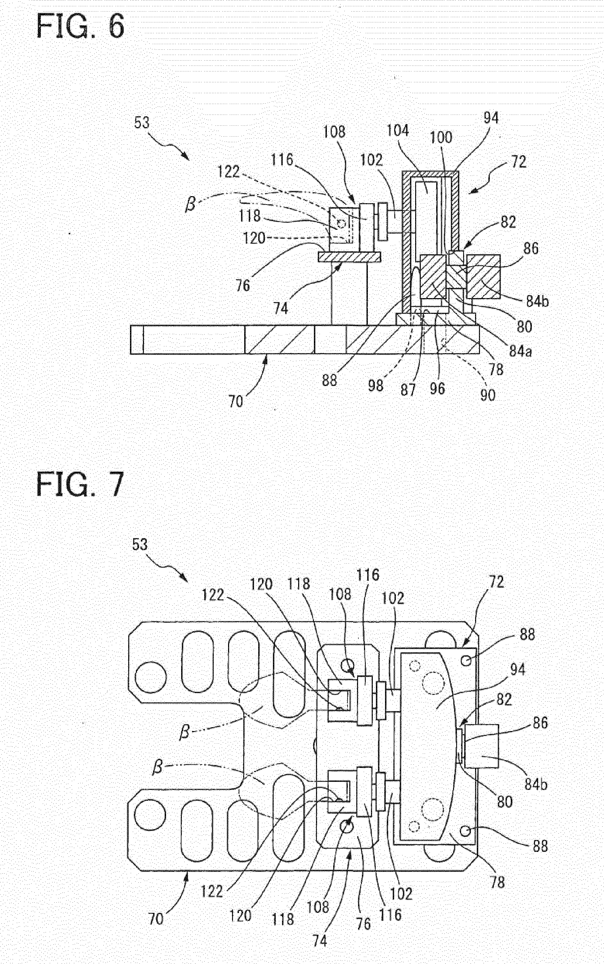

As shown in Fig. 4 and Fig. 6, at one end in the longitudinal direction (the horizontal direction in Fig. 4 and Fig. 6) of the pallet 70, a gear bracket 82 integrally including a base portion 78 and a supporting portion 80 is fixed. At the supporting portion 80 of the gear bracket 82, a rotation axis 86 is supported so as to extend in the longitudinal direction of the pallet 70 with a first non-contact gear 84a and a second non-contact gear 84b having a conventional structure provided at ends of the rotation axis 86. Further, an upper surface of the base portion 78 is made as a reference surface 87, which is a horizontal surface, and two positioning pins 88, 88 are integrally provided at the reference surface 87. At each end portion of the pallet 70 which is positioned at the side where the gear bracket 82 is fixed, a thrust pin through hole 90 is provided to penetrate through the pallet 70 and the base portion 78 of the gear bracket 82.

As shown in Fig. 4 to Fig. 8, the substrate-retaining jig 72 is placed on the reference surface 87 of the base portion 78 of the gear bracket 82.

As apparent from Fig. 4, Fig. 6, and Fig. 8, the substrate-retaining jig 72 includes a box-shaped casing 94 opening downward. At the opening of the casing 40, two internal flanges 96, 96 are integrally provided. Each of the two flanges 96, 96 has a positioning hole 98 penetrating therethrough.

Although not shown in the drawings, at an outer surface of the casing 94, a reflective portion is provided to reflect light emitted from the substrate retaining device detector sensor 63 consisting of a photoelectric sensor or an infrared ray sensor, for example. The first substrate-retaining device 52 and the second substrate-retaining device 53 have the reflective portion in different positions of the outer surface of the casing 94. By this reflective portion, based on the presence or absence of the reflected light of the light emitted from the substrate retaining device detector sensor 63, it can be detected whether or not the first substrate-retaining device 52 or the second substrate-retaining device 53 is supported on the supporting stations 60a to 60j, and based on the difference of the position where the light is reflected, it can be detected which one of the first substrate-retaining device 52 and the second substrate-retaining device 53 is supported, and which one of the substrate α and the substrate β is retained by the substrate-retaining device 52, 53, for example.

A cut-out 100 is provided at the lower part of one of two side walls opposing to each other in the width direction (the horizontal direction in Fig. 4 and Fig. 6) of the casing 94. At the other one of two side walls, two rotation axes 102, 102 are supported side by side so as to extend thought the side walls. At an end of each of the rotation axes 102 that is positioned at the side in the casing 94, a third non-contact gear 104 having a conventional structure is fixed.

Then, the casing 94 is provided on the gear bracket 82. Under such a state, the supporting portion 80 of the gear bracket 82 is engaged with the cut-out 100, and the two internal flanges 96, 96 are overlapped with the reference surface 87 of the base portion 78 of the gear bracket 82. Thus, the substrate-retaining jig 72 (casing 94) is arranged such that the center axis thereof extends in the vertical direction.

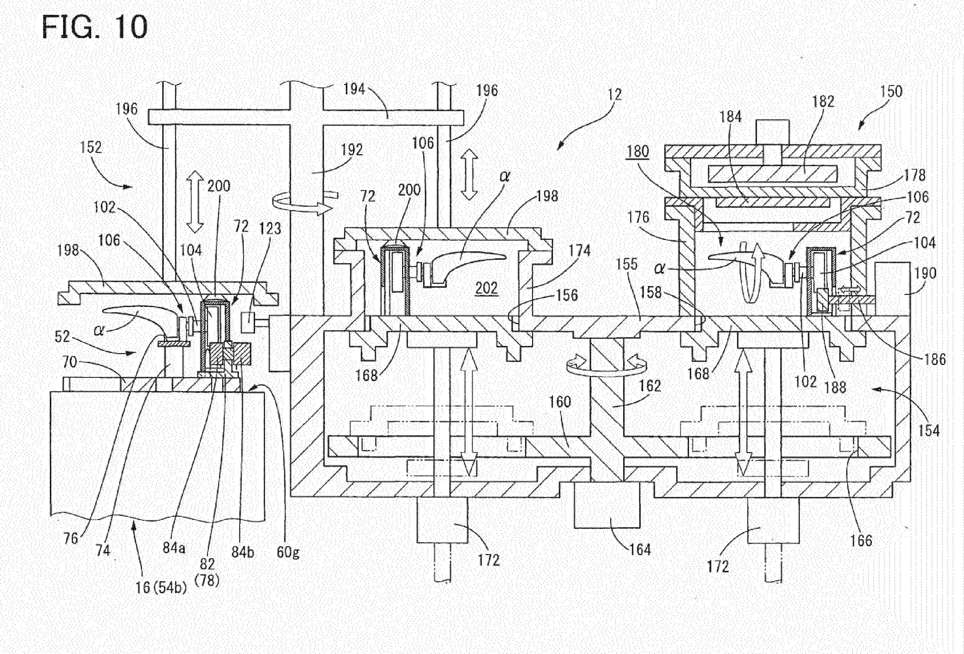

In a state where the casing 94 is mounted on the gear bracket 82, the first non-contact gear 84a fixed on one end of the rotation axis 86 is positioned close to, but not in contact with, the third non-contact gear 104 in the casing 94. Further, the second non-contact gear 84b fixed on the other end of the rotation axis 86 is positioned so as to protrude outwardly from the edge of the pallet 70. Then, the second non-contact gear 84b is rotationally driven together with the first non-contact gear 84a by the rotational drive of a non-contact drive gear 123 (see Fig. 10), which will be described later and which is rotationally driven by the driving motor (not shown) provided on the outer surface of the metal film deposition apparatus 12. Along with the rotational drive of the first and second non-contact gears 84a, 84b, the third non-contact gear 104 is rotationally driven.

As shown in Fig. 4 to Fig. 7, at the end portion of the rotation axis 102 that is projected from the casing 94 of each of the first substrate-retaining device 52 and the second substrate-retaining device 53, first and second substrate-retaining portion 106, 108 each capable of retaining the substrate α and β is respectively fixed. The first substrate-retaining portion 106 and the second substrate-retaining portion 108 constitute a first retaining portion and have different structures as described above.

As shown in Fig. 4 and Fig. 5, the first substrate-retaining portion 106 includes a stationary member 110 fixed at the end portion of the rotation axis 102 projected from the casing 94, and a fixing protrusion 112 provided at the stationary member 110. At a side surface of the fixing protrusion 112, a hemispherical locking protrusion 114 is provided in a projectable manner. The locking protrusion 114 is adapted to bias toward the outside by a spring (not shown) provided in the fixing protrusion 112 when the locking protrusion 114 is retracted into the side surface of the fixing protrusion 112. The fixing protrusion 112 of the first substrate-retaining portion 106 is adapted to fit in a fitting recess provided in the substrate α indicated by the two-dot chain line in Fig. 4 and Fig. 5. At that time, the locking protrusion 114 is locked on the substrate α while being biased by the spring (not shown).

The substrate α is removably mounted on the first substrate-retaining portion 106 due to the engagement of the fixing protrusion 112 with the fitting recess of the substrate α. Further, due to the engagement of the locking protrusion 114 with the substrate α, the substrate α is not easily detached from the first substrate-retaining portion 106. Thus, the substrate α mounted on the first substrate-retaining portion 106 is adapted to rotate around the rotation axis 102 along with the rotation of the third non-contact gear 104, together with the first substrate-retaining portion 106.

As shown in Fig. 6 and Fig. 7, the second substrate-retaining portion 108 includes a stationary member 116 fixed at the end portion of the rotation axis 102 projected from the casing 94, and a fixing portion 118 provided at the stationary member 116. At the fixing portion 118, a fitting recess 120 opening upward is provided, and at a side surface of the fitting recess 120, a hemispherical locking protrusion 122 is provided in a projectable manner. The locking protrusion 122 has the same structure as the locking protrusion 114 provided on the fixing protrusion 112 of the first substrate-retaining portion 106. Then, the substrate β indicated by the two-dot chain line in Fig. 6 and Fig. 7 is adapted to fit in the fitting recess 120 of the second substrate-retaining portion 108.

The substrate β is removably mounted on the second substrate-retaining portion 108 due to the engagement of the substrate β with the fitting recess 120 of the second substrate-retaining portion 108. Further, due to the engagement of the locking protrusion 122 with the substrate β, the second substrate-retaining portion 108 is not easily detached from the substrate β. Thus, the substrate β mounted on the second substrate-retaining portion 108 is adapted to rotate around the rotation axis 102 along with the rotation of the third non-contact gear 104, together with the second substrate-retaining portion 108.

The under surface of the fixing protrusion 112 of the first substrate-retaining portion 106 and the under surface of the fixing portion 118 of the second substrate-retaining portion 108 are each overlapped with the horizontal surface 76 of the table 74 of the pallet 70. By this arrangement, the first substrate-retaining portion 106 and the second substrate-retaining portion 108 cannot be rotated around the rotation axis 102. This position where the first and second substrate-retaining portions 106, 108 are restrained from rotating is referred to as a reference rotation position.

Although not shown in the drawings, each of the fixing protrusion 112 of the first substrate-retaining portion 106 and the fixing portion 118 of the second substrate-retaining portion 108 has a predetermined mark such as a line. When the first and second substrate-retaining portions 106, 108 are positioned at the reference rotation position, the marks on the fixing protrusion 112, the fixing portion 118, and the casing 94 are arranged so as to align with each other in a specific direction at a predetermines position. Thus, it can be easily determined whether the first and second substrate-retaining portions 106, 108 are positioned at the reference rotation position by checking the positional relationship among the respective mark of the fixing protrusion 112 and the fixing portion 118, and the mark of the casing 94.

As shown in Fig. 2, a mark detector sensor 121 consisting of a sensor camera, for example, is provided at the side of the first middle supporting station 60g of the second roller conveyor 54b to detect the positional relationship among the respective mark of the fixing protrusion 112 and the fixing portion 118, and the mark of the casing 94. Based on the signal detected from the mark detector sensor 121, the control unit for transfer area 66 determines whether the first and second substrate-retaining portions 106, 108 are positioned at the reference rotation position.

At the outer surface of the metal film deposition apparatus 12, the non-contact drive gear 123 that is rotationally driven by a driving motor (not shown) is provided so as to be positioned at the side of the first middle supporting station 60g (see Fig. 10). Then, when the control unit for transfer area 66 determines that the first and second substrate-retaining portions 106, 108 are not positioned at the reference rotation position, the non-contact dive gear 123 is rotationally driven under the control of the control unit for transfer area 66 to rotate the first and second non-contact gear 84a, 84b of the first and second substrate-retaining device 52, 53, and further the third non-contact gear 104. As a result, the first substrate-retaining portion 106 and the second substrate-retaining portion 108 are rotated to the reference rotation position. As apparent from this, in the present embodiment, the mark detector sensor 121, the non-contact drive gear 123, the driving motor that rotationally drive them, the first to third non-contact gears 84a, 84b, 104, and the table 74 constitute a positioning mechanism.

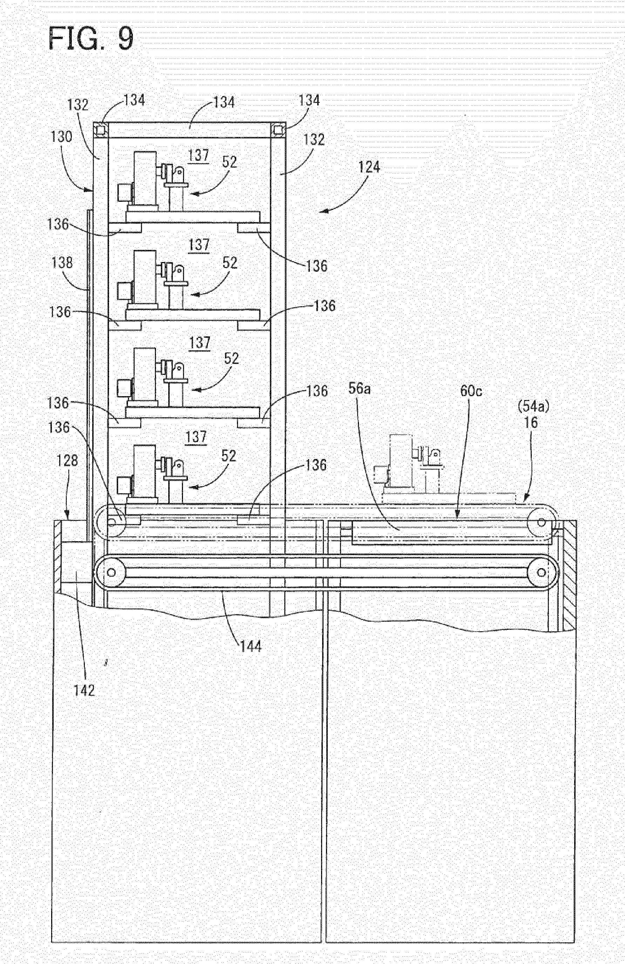

As shown in Fig. 1 to Fig. 3, in the transfer area 24, a first storage unit 124 and a second storage unit 126, which constitute first jig stockers, are provided for respectively storing the first substrate-retaining devices 52 and the second substrate-retaining devices 53 that have the above-described structure. The first storage unit 124 is provided at a position corresponding to the second middle supporting station 60c at the side of the first roller conveyor 54a of the transfer line 16. The second storage unit 126 is provided at a position corresponding to the third middle supporting station 60d at the side of the first roller conveyor 54a of the transfer line 16. The first storage unit 124 and the second storage unit 126 have the same structure. Thus, hereinafter, only the structure of the first storage unit 124 will be described in detail. With respect to the second storage unit 126, the same reference numerals as used in Fig. 2 and Fig. 9 are used for members and portions having the same structures as those of the first storage unit 124, and a detailed explanation of which is dispensed with.

As shown in Fig. 2 and Fig. 9, the first storage unit 124 includes a mount 128 and a vertical frame 130. The mount 128 consists of a box having an angular U-shaped cross section including three side walls on three sides other than the side of the second middle supporting station 60c. The vertical frame 130 includes four strut members 132, 132, 132, 132, which extend in the vertical direction parallel to each other, and some columnar connecting members 134, which connect the strut members 132 at the upper end and the lower end thereof.

The vertical frame 130 includes four sets of four plate-shaped supporting protrusions 136, which are spaced apart from each other in the vertical direction and fixedly provided so as to protrude inwardly from the strut members 132. This arrangement allows four of the first substrate-retaining devices 52, 52, 52, 52 to be stored in the vertical frame 130 such that they form a line in the vertical direction while four corners of each of the pallets 70 are supported by the plate-shaped supporting protrusions 136, 136, 136, 136. In other words, four storage spaces 137 for storing the first substrate-retaining device 52 are provided in the vertical frame 130 so as to form a line in the vertical direction. The number of the plate-shaped supporting protrusions 136 provided on the vertical frame 130 or the number of the storage spaces 137 may be suitably changed.

The vertical frame 130 can be moved up from and moved down into the mount 128 by a gear mechanism consisting of a rack 138 fixed on a outer surface of one strut member 132 and a pinion (not shown) in a gear box provided in the mount 128, and a driving motor (not shown) for driving the pinion to be rotated forwardly or reversely.

When the vertical frame 130 is positioned at the top dead point, a lower portion of one storage space 137 that is the lowest of the four storage spaces 137, 137, 137, 137 provided in the vertical frame 130 is positioned at the substantially same level as the upper surface of the second middle supporting station 60c. When the vertical frame 130 is positioned at the bottom dead point, a lower portion of one storage space 137 that is the uppermost of the four storage spaces 137, 137, 137, 137 provided in the vertical frame 130 is positioned at the substantially same level as the upper surface of the second middle supporting station 60c. Then, each of the storage spaces 137 is adapted to be positioned at the substantially same level as the upper surface of the second middle supporting station 60c, every time the driving motor (not shown) rotationally drives a predetermined amount.

Two carrying belts 144, 144 are provided so as to extend between the mount 128 and the second middle supporting station 60c with rotating ends being positioned at each side in the horizontal direction. These carrying belts 144, 144 are allowed to travel by the same structure as the carrying belts 62, 62, and move upward and downward between a position (position indicated by the two-dot chain line in Fig. 9) higher from the upper surface of the second middle supporting station 60c and a position (position indicated by the solid line in Fig. 9) lower than the upper surface of the second middle supporting station 60c.

The first substrate-retaining device 52 and the second substrate-retaining device 53, respectively stored in the first storage unit 124 and the second storage unit 126, which has the above-described structure, are automatically removed from the first and second storage units 124, 126 under the control of the control unit for transfer area 66, and moved onto the second middle supporting station 60c and the third middle supporting station 60d to be supported thereon. As described above, the first storage unit 124 and the second storage unit 126 have the same structure. Thus, only the automatic removal of the first substrate-retaining device 52 from the first storage unit 124 will be described in detail, and the explanation of the automatic removal of the second substrate-retaining device 53 from the second storage unit 126 is dispensed with.

Specifically, when the first substrate-retaining device 52 is automatically removed from the first storage unit 124, the substrate retaining device detector sensor 63 and the control unit for transfer area 66 that are positioned corresponding to the second middle supporting station 60c (see Fig. 1) determine whether or not the first substrate-retaining device 52 and the second substrate-retaining device 53 are supported on the second middle supporting station 60c. When it is determined that no substrate-retaining device is supported, the vertical frame 130 is moved up or down (vertical movement) under the control of the control unit for transfer area 66 such that the storage space 137 containing the first substrate-retaining device 52 is positioned at the substantially same level as the upper surface of the second middle supporting station 60c. If the storage space 137 containing the first substrate-retaining device 52 is already positioned at the substantially same level as the upper surface of the second middle supporting station 60c, the vertical frame 130 will not be moved up or down.

Here, the control unit for transfer area 66 always recognizes which one of the four storage spaces 137, 137, 137, 137 stores the first substrate-retaining device 52. Thus, when the storage space 137 containing the first substrate-retaining device 52 is positioned at the same level as the upper surface of the second middle supporting station 60c, the vertical frame 130 is moved up or down by an amount and in a direction that are determined based on the data of the first substrate-retaining device 52 that is held on the control unit for transfer area 66.

Then, as shown in Fig. 9 by the two-dot chain line, the two carrying belts 144, 144 are moved up, and the first substrate-retaining device 52 stored in the storage space 137 is transferred from the four supporting protrusions 136, 136, 136, 136 onto the two carrying belts 144, 144 and supported thereby. Due to the travel of the carrying belts 144, 144 by the forward rotational drive of the driving motor (not shown), under such a circumstance, the first substrate-retaining device 52 is removed from the first storage unit 124 (storage space 137) and moved onto the second middle supporting station 60c. After that, when the travel of the carrying belts 144, 144 are stopped, the carrying belts 144, 144 are moved down. As a result, the first substrate-retaining device 52 removed from the first storage unit 124 is supported on the second middle supporting station 60c.

When the first substrate-retaining device 52 is transferred to the second middle supporting station 60c, the first substrate-retaining device 52 is automatically stored into the first storage unit 124 from the second middle supporting station 60c under the control of the control unit for transfer area 66. Further, when the second substrate-retaining device 53 arrives at the third middle supporting station 60d, the second substrate-retaining device 53 is automatically stored into the second storage unit 126 from the third middle supporting station 60d under the control of the control unit for transfer area 66. The first substrate-retaining device 52 is automatically stored into the first storage unit 124 in the same way as the second substrate-retaining device 53 is automatically stored into the second storage unit 126. Thus, only the way of storing the first substrate-retaining device 52 into the first storage unit 124 will be explained in detail, and the explanation of the way of storing the second substrate-retaining device 53 into the second storage unit 126 is dispensed with.

Initially, when the substrate retaining device detector sensor 63 detects that the first substrate-retaining device 52 is transferred from the upstream side and supported on the second middle supporting station 60c, the vertical frame 130 is moved up such that the storage space 137 that does not store the first substrate-retaining device 52 is positioned at the same level as the upper surface of the second middle supporting station 60c. If the storage space 137 that does not store the first substrate-retaining device 52 is already positioned at the same level as the upper surface of the second middle supporting station 60c, the vertical frame 130 will not be moved up.

Subsequently, the carrying belts 144, 144 are moved up, and the first substrate-retaining device 52 supported on the second middle supporting station 60c are transferred onto the carrying belts 144, 144 in order to be supported thereon. Under such a circumstance, the carrying belts 144, 144 are traveled along with the reverse rotational drive of the driving motor (not shown), in the direction opposite to the direction in which the first substrate-retaining device 52 is removed from the first storage unit 124. Consequently, the first substrate-retaining device 52 is transferred into the storage space 137 from the second middle supporting station 60c. Then, when the carrying belts 144, 144 stop traveling, the two carrying belts 144, 144 are moved down. Therefore, the first substrate-retaining device 52 transferred into the storage space 137 is supported on the four plate-shaped supporting protrusions 136, 136, 136, 136. As a result, the first substrate-retaining device 52 is stored into the first storage unit 124 in a state where the first substrate-retaining device 52 is supported on the plate-shaped supporting protrusions 136 in the predetermined storage space 137.

It is to be understood that the first substrate-retaining device 52 or the second substrate-retaining device 53 that is transferred onto the second middle supporting station 60c or the third middle supporting station 60d from the upstream side is not necessarily automatically stored into the first storage unit 124 or the second storage unit 126. In some cases, the first substrate-retaining device 52 or the second substrate-retaining device 53 is transferred to the terminal side supporting station 60e side without being stored into the first storage unit 124 or the second storage unit 126.

Here, since the substrate retaining device detector sensor 63 positioned corresponding to the second middle supporting station 60c or the third middle supporting station 60d works in cooperation with the control unit for transfer area 66, it can be prevented that the first substrate-retaining device 52 is automatically stored into the second storage unit 126 from the third middle supporting station 60d, or the second substrate-retaining device 53 is automatically stored into the first storage unit 124 from the second middle supporting station 60c.

In the present embodiment, the first substrate-retaining device 52 and the second substrate-retaining device 53 are removed from the first storage unit 124 and the second storage unit 126 automatically in the molding order of the substrates α and β by the first and second injection molding apparatuses 10a, 10b.

Specifically, as described above, the substrate molding order detector signal that is obtained by converting the molding order of the substrates α and β by the first and second injection molding apparatuses 10a, 10b into signal is input into the control unit for transfer area 66 from the control unit for molding area 44 from the very start of the molding of the substrates α and β. In the control unit for transfer area 66, based on the substrate molding order detector signal, the removal order of the first and substrate-retaining devices 52, 53 from the first and second storage units 124, 126 is determined such that the removal order of the first and second substrate-retaining devices 52, 53 from the first and second storage units 124, 126 and the molding order of the substrates α and β correspond to each other. Then, in the removal order of the first and second substrate-retaining device 52, 53, the first substrate-retaining device 52 and the second substrate-retaining device 53 are removed from the first and second storage units 124, 126 under the control of the control unit for transfer area 66 and supported on the second middle supporting station 60c and the third middle supporting station 60d. As apparent from this, the control unit for transfer area 66 constitutes a first decision unit.

The first substrate-retaining device 52 or the second substrate-retaining device 53 automatically removed from the first storage unit 124 or the second storage unit 126 is transferred to the terminal side supporting station 60e from the second middle supporting station 60c or the third middle supporting station 60d.

Before the first substrate-retaining device 52 or the second substrate-retaining device 53 is removed from the first storage unit 124 or the second storage unit 126 in the molding order of the substrate α or the substrate β (in the removal order of the of the first and second substrate-retaining devices 52, 53), if the first or second substrate-retaining device 52, 53 to be removed is transferred onto the second middle supporting station 60c or the third middle supporting station 60d from the upstream side, the first or second substrate-retaining device 52, 53 is not removed from the first storage unit 124 or the second storage unit 126, and the first or second substrate-retaining device 52, 53, which is on the second or third middle supporting station 60c, 60d, is transferred to the terminal side supporting station 60e.

In the present embodiment, when the molding of the substrate α and the substrate β by the first and second injection molding apparatuses 10a, 10b start, the first substrate-retaining device 52 for retaining the substrate α and the second substrate-retaining device 53 for retaining the substrate β are transferred to the terminal side supporting station 60e in the order corresponding to the molding order of the substrate α and the substrate β. Then, the substrate α and the substrate β transferred to the terminal point of the transfer conveyor 32 are allowed to be retained by the first substrate-retaining device 52 and the second substrate-retaining device 53 in the molding order.

As shown in Fig. 1, the metal film deposition apparatus 12 provided in the metal film deposition area 20 includes a sputtering apparatus 150 and a transfer machine 152. The sputtering apparatus 150 is placed at the side of the first middle supporting station 60g of the second roller conveyor 54b (the transfer line 16). The transfer machine 152 is positioned so as to extend across the gap between the first middle supporting station 60g of the second roller conveyor 54b and the sputtering apparatus 150.

More specifically described, as shown in Fig. 10, the sputtering apparatus 150 includes a vacuum chamber 154. At a top board 155 of the vacuum chamber 154, a left window 156 and a right window 158 are provided. In the vacuum chamber 154, a circular rotating table 160 having a through hole 166 is provided. The rotating table 160 is arranged to rotate forwardly or reversely around the rotation axis 162, which extends in the vertical direction, with the rotational drive of the rotary driving device 164.

At positions above the rotating table 160 in the vacuum chamber 154 which correspond to the left window 156 and the right window 158, support tables 168 are provided in a vertically movable manner by lifts 172, 172. The support tables 168, 168 are moved up by the lifts 172, 172 to close lower openings of the left and right windows 156, 158 of the top board 155. Further, as indicated by the two-dot chain line in Fig. 10, the support tables 168, 168 are retained by the rotating table 160 when they are moved down by the lifts 172, 172.

At a periphery of the opening of each of the left and right windows 156, 158 of the top board 155 of the vacuum chamber 154, a left tubular wall 174 and a right tubular wall 176 are integrally provided, respectively. The right tubular wall 176 is sealed air-tightly at an upper opening thereof by a cover 178 that can transmit magnetic force. Thus, when the right window 158 is sealed by the support table 168, the inner space of the right tubular wall 176 is disconnected from the vacuum chamber 154, thereby forming a sputtering chamber 180. Further, a permanent magnet 182 is provided above the cover 178, and a target 184 that emits sputtering particles is provided at a lower surface of the cover 178.

In the sputtering chamber 180, a non-contact gear 188 is provided in a rotatable manner by a driving motor (not shown) provided in a drive unit 190. The non-contact gear 188 can be moved horizontally between the position indicated by the two-dot chain line and the position indicated by the solid line in Fig. 10 by a movement mechanism (not shown) provided in the drive unit 190.

The transfer machine 152 includes: a rotation axis 192 that is connected to a rotationally driving means (not shown) and fixed to the top board 155 of the sputtering apparatus 150; a supporting bar 194 that extends horizontally from the rotation axis 192; lifting rods 196, 196 that are fixed to both ends of the supporting bar 194 in a vertically movable manner; and two jig chuckers 198, 198 that are fixed to the lower ends of the lifting rods 196, 196.

One of the jig chuckers 198, 198 is positioned above the first middle supporting station 60g of the second roller conveyor 54b, and the other one of the jig chuckers 198, 198 is positioned above the left tubular wall 174 (the left window 156) of the top board 155. Each of the jig chuckers 198 is provided with an absorber 200 that is connected to an air suction pump (not shown). The absorber 200 absorbs and retains the substrate-retaining jig 72 of the first or second substrate-retaining device 52, 53 by the operation of the air suction pump.

As shown in Fig. 1, in the metal film deposition area 20, in addition to the metal film deposition apparatus 12 having the above-described structure, a control unit for metal film deposition area 204 is provided. Substrate retaining device detector signals output from the two substrate retaining device detector sensors 63, 63, which are positioned so as to correspond to the first middle supporting station 60g and the second middle supporting station 60h, are inputted to the control unit for metal film deposition area 204.

Based on the substrate retaining device detector signals output from the two substrate retaining device detector sensors 63, 63, the metal film deposition apparatus 12 is operated while being controlled by the control unit for metal film deposition area 204. Further, by the operation of the metal film deposition apparatus 12, the substrate α or the substrate β that is supported by the first or second substrate-retaining device 52, 53 on the first middle supporting station 60g is transferred into the sputtering apparatus 150 in order to form a metal film on the surface of the substrate α or β. As apparent from this, in the present embodiment, the first middle supporting station 60g constitutes a second substrate supporting station. Hereinafter, the operation of the metal film deposition apparatus 12 during the formation process of the metal film will be described. The operation will be described by taking the operation of the metal film deposition apparatus 12 for forming the metal film on a surface of the substrate α as an example, with reference to Fig. 10.

Specifically, when the first substrate-retaining device 52 retaining the substrate α using the substrate-retaining jig 72 is transferred to the first middle supporting station 60g of the second roller conveyor 54b by the transfer line 16, the substrate retaining device detector signal is inputted to the control unit for transfer area 66 and the control unit for metal film deposition area 204 (see Fig. 1).

The four lifting pins 67, 67, 67, 67 and the two thrust pins 68, 68 provided in the first middle supporting station 60g are protruded upon input of the substrate retaining device detector signal to the control unit for transfer area 66, thereby lifting the pallet 70 and the substrate-retaining jig 72 of the substrate-retaining device 52 supported by the first middle supporting station 60g. Thus, the second non-contact gear 84b is positioned closer to the non-contact drive gear 123 provided at the side surface of the transfer machine 152, allowing the rotation of the first substrate-retaining portion 106 of the first substrate-retaining device 52 by the non-contact drive gear 123. In addition, the first substrate-retaining portion 106 and the substrate α are allowed to integrally rotate around the rotation axis 102 while the fixing protrusion 112 of the first substrata retaining portion 106 is spaced apart from the horizontal surface 76 of the table 74 provided on the pallet 70.

Based on the input of the substrate retaining device detector signal to the control unit for metal film deposition area 204, the transfer machine 152 is operated under the control of the control unit for metal film deposition area 204, and the substrate-retaining jig 72 of the first substrate-retaining device 52 supported by the first middle supporting station 60g is absorbed by the absorber 200 of the jig chucker 198 and retained thereby. The rotation around the rotation axis 192 and the vertical movement of the jig chucker 198 transfers the substrate-retaining jig 72 to the inner space of the left tubular wall 174 of the sputtering apparatus 150 from the base portion 78 of the gear bracket 82 of the first substrate-retaining device 52, with the substrate α retained, whereby the substrate retaining jig 72 is supported by the support table 168 closing the left window 156. In this way, the substrate-retaining jig 72 and the substrate α retained thereby are transferred into the metal film deposition apparatus 12.

At this time, the retention by the absorber 200 is cancelled, and the upper opening of the left tubular wall 174 is closed air tightly by the jig chucker 198, so that the inner space of the left tubular wall 174 provides a load rock chamber 202. Further, the jig chucker 198 that is previously positioned on the left tubular wall 174 is transferred onto the first middle supporting station 60g. The transfer machine 152 is operated upon completion of a lift of the pallet 70 and the substrate-retaining jig 72 of the substrate-retaining device 52 supported on the first middle supporting station 60g.

After the load lock chamber 202 is provided, the pressure of the inner space of the chamber 202 is reduced. When the pressure in the load lock chamber 202 is reduced to substantially the same pressure as the pressure in the vacuum chamber 154, the support table 168 supporting the substrate-retaining jig 72 is moved to the right window 158 from the left window 156 by the vertical movement of the lifts 172, 172 and the rotation of the rotating table 160, thereby closing the right window 158 by the support table 168. Thus, the sputtering chamber 180 is provided by the inner space of the right tubular wall 176, and the substrate α is contained in the sputtering chamber 180 while being retained by the substrate-retaining jig 72.

After the substrate α and the substrate-retaining jig 72 are contained in the sputtering chamber 180, the drive unit 190 starts to operate to rotationally drive the non-contact gear 188 that is fixed on a rotation axis 186 extending from the drive unit 190, and the non-contact gear 188 is moved from the position indicated by the two-dot chain line in Fig. 10 to the position indicated by the solid line such that the non-contact gear 188 enters the casing 94 of the substrate-retaining jig 72. The rotational drive of the non-contact gear 188 in the casing 94 rotationally drives the third non-contact gear 104 in the casing 94, whereby the substrate-retaining portion 106 and the substrata α are integrally rotated around the rotation axis. As apparent from this, in the present embodiment, the drive unit 190, the rotation axes 102, 186, the third non-contact gear 104 and the non-contact gear 188 constitute a rotation mechanism.

After the substrate α and the substrate-retaining jig 72 are contained in the sputtering chamber 180, a predetermined sputtering gas is introduced into the sputtering chamber 180 through a gas inlet (not shown), and by the application of a negative voltage to the target 184, sputtering operation is performed while the substrate α is rotated in the sputtering chamber 180. The sputtering operation is performed by conventional magnetron sputtering that utilizes magnetic force of the permanent magnet 182. Thus, a metal film consisting of a sputtering film is formed on a whole surface of the substrate α. As a result, an intermediate product including a metal film on a surface of the substrate α is produced.

In the present embodiment, before the above-described sputtering operation starts, the control unit for metal film deposition area 204 determines a kind of substrate (here, the substrate α) that is positioned in the sputtering chamber 180 of the sputtering apparatus 150 based on the substrate retaining device detector signal inputted to the control unit for metal film deposition area 204 by the substrate retaining device detector sensor 63 positioned corresponding to the first middle supporting station 60g. Then, the deposition condition (deposition time, for example) of the metal film (sputtering film) is selected by the control unit for metal film deposition area 204 from the various conditions varied depending on the kind of substrate (substrate α or substrate β) and stored in the control unit for metal film deposition area 204. Under such a deposition condition determined as above, the sputtering on the surface of the substrate (here, the substrate α) is operated. As apparent from the above, in the present embodiment, the control unit for metal film deposition area 204 constitutes a discrimination unit and a second decision unit. It is to be understood that the discrimination unit and the second decision unit may be constituted by separate control units, for example. Hereinafter, an intermediate product including the metal film on the surface of the substrate α is referred to as an intermediate product α, and an intermediate product including the metal film on the surface of the substrate β is referred to as an intermediate product β.

After the formation operation of the metal film on the surface of the substrate α (the production operation of the intermediate product α) is finished, the metal film deposition apparatus 12 is operated in the reverse order of the storing order of the substrate α and the substrate-retaining jig 72 into the sputtering chamber 180, under the control of the control unit for metal film deposition area 204. By this operation, the intermediate product α is returned on the base portion 78 of the gear bracket 82 of the first substrate-retaining device 52 supported on the first middle supporting station 60g. As apparent from this, in the present embodiment, the transfer machine 152 constitutes a substrate carrying machine and an intermediate product removal machine. Further, the first middle supporting station 60g of the second roller conveyor 54b constitutes a second substrate supporting station and a first intermediate product supporting station.

Hereinabove, the process is explained which includes the steps of transferring the substrate α into the metal film deposition apparatus 12, forming a metal film on the substrate α to produce an intermediate product α, and removing the intermediate product α from the metal film deposition apparatus 12. However, it is to be understood, in the present embodiment, that the transfer of the substrate α into the metal film deposition apparatus 12 is concurrently conducted with the removal of the intermediate product α from the metal film deposition apparatus 12 by the transfer machine 152, while the sputtering operation to the substrate α is conducted at the same time.

While the first substrate-retaining device 52 supported on the first middle supporting station 60g stands by, the lifting pins 67 and the thrust pins 68 keep protruding. This condition is maintained until the substrate-retaining jig 72 and the intermediate product α supported thereby are removed from the metal film deposition apparatus 12 and returned onto the first substrate-retaining device 52.

After the substrate-retaining jig 72 removed from the sputtering apparatus 150 is returned to the base portion 78 of the gear bracket 82 of the first substrate-retaining device 52 supported on the first middle supporting station 60g, the non-contact drive gear 123 is rotated by a predetermined amount under the control of the control unit for transfer area 66 based on the signal inputted from the mark detector sensor 121. The rotation of the non-contact drive gear 123 rotates the first substrate-retaining portion 106 to the reference rotation position along with the rotation of the third non-contact gear 104. Thus, the substrate α supported on the first substrate-retaining portion 106 is positioned at the same place as before transferred into the sputtering apparatus 150.

Then, each of the thrust pins 68 is retracted, and the substrate-retaining jig 72 is moved down. As a result, the fixing protrusion 112 of the first substrate-retaining portion 106 is brought into abutting contact with the horizontal surface 76 of the table 74 provided on the pallet 70. Thus, the rotation of the first substrate-retaining portion 106 around the rotation axis 102 is prevented.

Subsequently, each of the lifting pins 67 is retracted, and the entire of the first substrate-retaining device 52 is moved down. The second non-contact gear 84b and the non-contact drive gear 123 are positioned so as to have a predetermined distance therebetween such that the second non-contact gear 84b protruding from the substrate-retaining portion 72 does not contact with the non-contact drive gear 123 protruding from the side wall of the transfer machine 152 during the transfer of the first substrate-retaining device 52 on the transfer line 16. After the retraction of the lifting pins 67, the first substrate-retaining device 52 supported on the first middle supporting station 60g is sent to the second middle supporting station 60h while supporting the substrate-retaining jig 72 and the intermediate product α retained thereby.

The first substrate-retaining device 52 and the second substrate-retaining device 53 have the same structure, except for the structure of the substrate-retaining jig 72. Thus, in the case where the sputtering operation is performed on both of the substrate α and the substrate β, if the substrate is not transferred into the sputtering apparatus 150 upon removal of the intermediate product supported by the support table 168, the substrate retaining device supported on the first middle supporting station 60g may be any one of the first substrate-retaining device 52 and the second substrate-retaining device 53. However, if the substrate is transferred into the sputtering apparatus 150 upon removal of the intermediate product supported on the support table 168, the control unit for metal film deposition area 204 determines the kind of the substrate retaining device to be supported on the first middle supporting station 60g depending on the kind of the substrate to be transferred.

In the present embodiment, in the case where the metal film deposition apparatus 12 is continuously operated, after the first or second substrate-retaining device 52, 53, in which the substrate-retaining jig 72 retaining the intermediate product α or β is returned on the base portion 78 of the gear bracket 82, is transferred to the second middle supporting station 60h from the first middle supporting station 60g, another first or second substrate-retaining device 52, 53 is transferred to the first middle supporting station 60g from the start side supporting station 60f. Then, upon completion of the transfer, the intermediate product α or β is removed from the metal film deposition apparatus 12 by the transfer machine 152.

At that time, if the substrate α or β is retained on the first or second substrate-retaining device 52, 53 transferred onto the first middle supporting station 60g, concurrently with the removal of the intermediate product α or β from the metal film deposition apparatus 12, the substrate α or β is carried into the metal film deposition apparatus 12.

The linked operation of the transfer line 16 and the metal film deposition apparatus 12, and the linked operation of the transfer machine 152 and the sputtering apparatus 150 in the metal film deposition apparatus 12 are conducted under the control of the control unit for metal film deposition area 204. As apparent from this, the control unit for metal film deposition area 204 constitutes a second control unit.

As shown in Fig. 1, the coating film forming apparatus 14 provided in the coating film formation area 22 includes: a circulation device 206 that supports and allows the substrate α or β to circulate the entire of the coating film formation area 22; a coating chamber 208; and a drying chamber 210, which are provided on the middle of the circulation device 206.

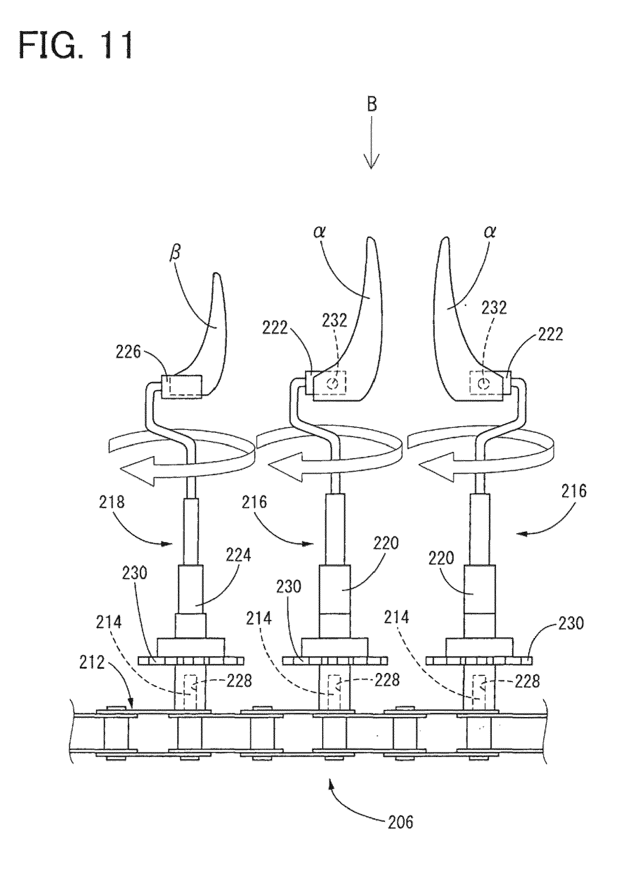

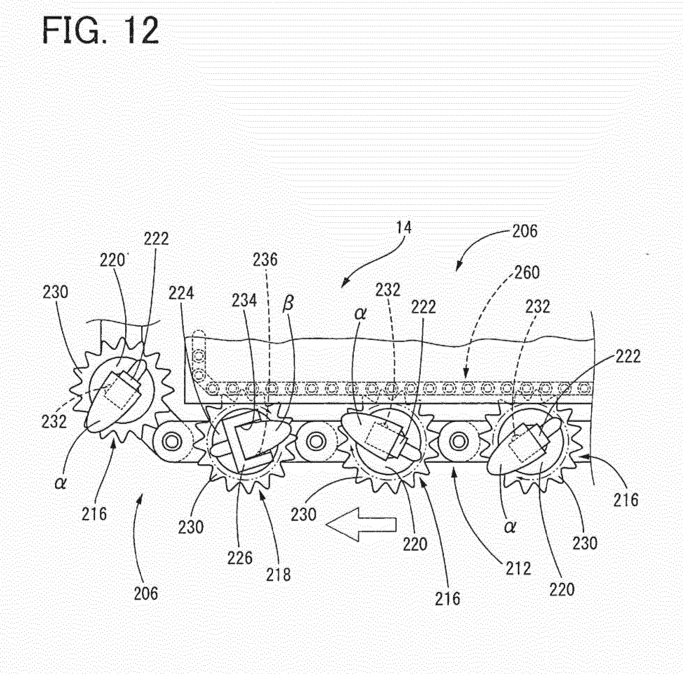

More specifically described, as shown in Fig. 11 and Fig. 12, the circulation device 206 includes a chain conveyor 212 that circulates in the coating film forming apparatus 14 in the direction indicated by an arrow in Fig. 1. On the chain conveyor 212, a plurality of supporting pins 214 are vertically provided so as to space apart from each other with a predetermined distance therebetween. A first intermediate product retaining device 216 or a second intermediate product retaining device 218 as a second retaining jig is supported by the supporting pins 214 while retaining the intermediate product α or the intermediate product β.

Each of the first intermediate product retaining device 216 and the second intermediate product retaining device 218 integrally includes a retaining device body 220, 224, and an intermediate product retaining portion 222, 226, which is a second retaining portion that retains the substrate α or the substrate β. Each of the retaining device bodies 220, 224 of the first and second intermediate product retaining devices 216, 218 is engaged with the supporting pins 214 at an engagement recess 228, and sprockets 230 provided on the retaining device bodies 220, 224 are engaged with a chain belt 260 extending along the chain conveyor 212.

The intermediate product retaining portions 222 of the first intermediate product retaining device 216 includes a hemispherical locking protrusion 232 at a side surface thereof in a projectable manner. When the intermediate product retaining portion 222 fits in the fitting recess of the intermediate product α, the locking protrusion 232 is locked while being biased by a spring member (not shown), thereby removably fixing and retaining the intermediate product α onto the intermediate product retaining portions 222.

The intermediate product retaining portions 226 of the second intermediate product retaining device 218 includes a fitting recess 234, and at a side surface of the fitting recess 234, a hemispherical locking protrusion 236 is provided in a projectable manner. When a part of the intermediate product β fits in the fitting recess 234 of the intermediate product retaining portion 226, the locking protrusion 236 is locked while being biased by a spring member (not shown), thereby removably fixing and retaining the intermediate product β onto the intermediate product retaining portions 226.

Thus, the intermediate product α and the intermediate product β are circulated in the coating film forming apparatus 14, together with the first intermediate product retaining device 216 and the second intermediate product retaining device 218 in the direction indicated by an arrow in Fig. 1, by the travel of the chain conveyor 212, while rotating around the center axis of the first or second intermediate product retaining device 216, 218.

Here, a carry-in station 237 is a part of the circulation device 206 that is positioned close to the start side supporting station 60a of the first roller conveyor 54a on the transfer line 16. Between the carry-in station 237 and the start side supporting station 60a of the first roller conveyor 54a, a carry-in device 239 including a robot arm 238 is provided.

At the side of the carry-in station 237 of the circulation device 206, a detector sensor for intermediate product retaining device 241 a is provided for detecting which one of the first intermediate product retaining device 216 and the second intermediate product retaining device 218 is positioned at the carry-in station 237, and an intermediate product detector sensor 243 is provided for detecting whether or not the first intermediate product retaining device 216 or the second intermediate product retaining device 218 retains the intermediate product α or the intermediate product β. The detector sensors 241 a, 243 are arranged to output the detection signals to the control unit for coating film formation area 254 provided in the coating film formation area 22. Here, the detector sensor for intermediate product retaining device 241 a and the intermediate product detector sensor 243 are each constituted by a sensor camera, for example.

When the intermediate product α or β is transferred to the start side supporting station 60a by the transfer line 16 while being retained by the first or second substrate-retaining device 52, 53, the robot arm 238 of the carry-in device 239 removes the intermediate product α or β from the first or second substrate-retaining device 52, 53 and carries it to the carry-in station 237 of the circulation device 206 so as to be retained by the first or second intermediate product retaining device 216, 218 that is positioned at the carry-in station 237. The first or second substrate-retaining device 52, 53 from which the intermediate product α or β is removed is transferred to the downstream side by the transfer line 16.

The intermediate product α or β is carried in by the operation of the carry-in device 239 under the control of the control unit for coating film formation area 254 only when the detector sensor for intermediate product retaining device 241 a and the intermediate product detector sensor 243 detect that the first or second intermediate product retaining device 216, 218 that does not retain the intermediate product α or β is positioned at the carry-in station 237. As apparent from this, in the present embodiment, the start side supporting station 60a of the first roller conveyor 54a constitutes a second intermediate product supporting station, and the carry-in device 239 constitutes an intermediate product transfer apparatus.

As shown in Fig. 1, a third storage unit 240 and a fourth storage unit 242, which constitute second jig stockers, are provided at the side of the circulation device 206 for separately storing the first intermediate product retaining devices 216 and second intermediate product retaining devices 218. The third and fourth storage units 240, 242 are positioned at the side of the downstream end in the transfer direction (circulation direction) of the intermediate product α or β by the circulation device 216. Since the third storage unit 240 and the fourth storage unit 242 have the same structure, only the structure of the third storage unit 240 will be explained, and the explanation of the structure of the fourth storage unit 242 is dispensed with.

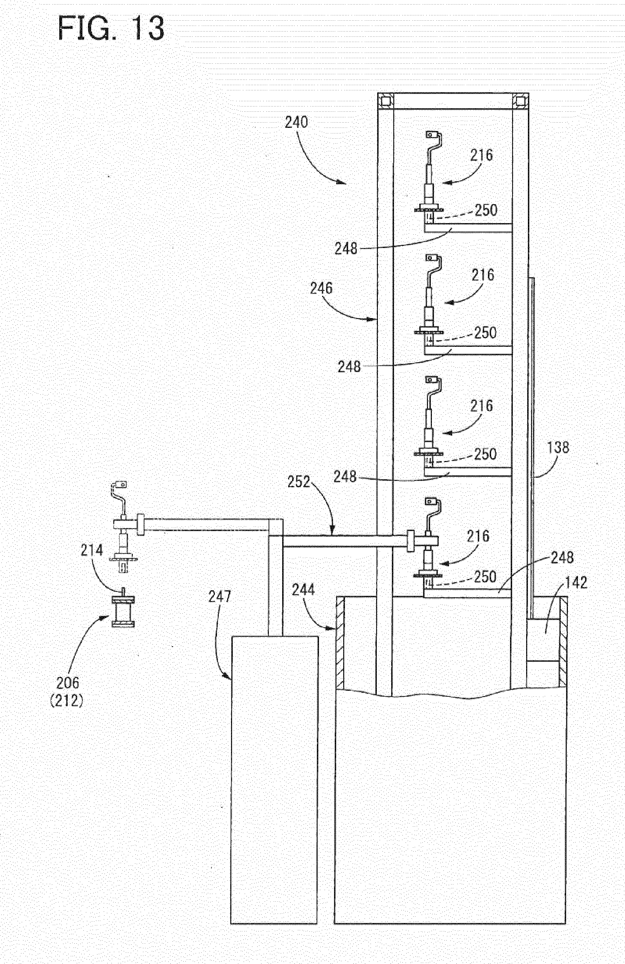

As shown in Fig. 13, the third storage unit 240 includes a mount 244, a vertical frame 246 placed in the mount 244, and an automatic exchanging machine 247 positioned between the mount 244 and the chain conveyor 212 of the circulation device 206.

The vertical frame 246 of the third storage unit 240 can be moved up or down by a combination of a rack 138 fixed to the vertical frame 246, a pinion (not shown) in the gear box 142 provided in the mount 244, and a driving motor (not shown). A supporting arm 248 is provided at a plurality of positions of the vertical frame 246 so as to space apart from each other with a predetermined distance therebetween in the vertical direction. The first intermediate product retaining device 216 can be supported by a supporting pin 250 provided at an end portion of the supporting arm 248.

The automatic exchanging machine 247 includes a robot arm 252. The operation of the robot arm 252 moves the first intermediate product retaining device 216 between the inside of the vertical frame 246 and the chain conveyor 212 such that the first intermediate product retaining device 216 is removed from the third storage unit 240 or is stored in the third storage unit 240.

As shown in Fig. 1, in the present embodiment, a detector sensor for intermediate product retaining device 241 b, for example consisting of a sensor camera, is provided at the upper stream side of the third and fourth storage units 240, 242 in the travel direction of the chain conveyor 212 of the circulation device 206. The detector sensor for intermediate product retaining device 241 b and the control unit for coating film formation area 254 work in cooperation to control the operation of the third storage unit 240 and the fourth storage unit 242.

Specifically, the detector sensor for intermediate product retaining device 241 b detects which one of the first intermediate product retaining device 216 and the second intermediate product retaining device 218 is to be transferred onto the chain conveyor 212, and detection signal is output to the control unit for coating film formation area 254. Then, based on the detection signal, one of the third storage unit 240 and the fourth storage unit 242 starts its operation. When the first intermediate product retaining device 216 is transferred onto the chain conveyor 212, the first intermediate product retaining device 216 is stored in the third storage unit 240. When the second intermediate product retaining device 218 is transferred onto the chain conveyor 212, the second intermediate product retaining device 218 is stored in the fourth storage unit 242.

At the time of removal of the first and second intermediate product retaining devices 216, 218 from the third and fourth storage units 240, 242, the operations of the third and fourth storage units 240, 242 are controlled by the control unit for coating film formation area 254 such that the first intermediate product retaining device 216 and the second intermediate product retaining device 218 are transferred to the carry-in station 237 in the order corresponding to the transfer order of the intermediate product α and the intermediate product β to the carry-in station 237 of the circulation device 206 by the carry-in device 239.

More specifically described, the substrate molding order detector signal which is obtained by converting the molding order of the substrate α and β is inputted to the control unit for coating film formation area 254 from the control unit for molding area 44. The control unit for coating film formation area 254 determines the production order of the intermediate products α and β in the metal film deposition apparatus, based on the substrate molding order detector signal input thereto. The production order is also regarded as the transfer order of the intermediate product α and β transferred into the carry-in station 237 of the circulation device 206. Further, based on the transfer order determined as above, the removal order of the first and second intermediate product retaining devices 216, 218 from the third and fourth storage units 240, 242 are determined. Then, based on the removal order, the third and fourth storage units 240, 242 are operated under the control of the control unit for coating film formation area 254. Accordingly, the first intermediate product retaining device 216 and the second intermediate product retaining device 218 are transferred by the circulation device 206, so as to be positioned at the carry-in station 237 in the transfer order of the intermediate products α and β transferred to the carry-in station 237 of the circulation device 206. As apparent from this, in the present embodiment, the control unit for coating film formation area 254 constitutes a third decision unit.

At the time of transfer of the first intermediate product retaining device 216 or the second intermediate product retaining device 218 to the carry-in station 237, in some cases, the first or second intermediate product retaining device 216, 218 is transferred to the carry-in station 237 without being stored in the third or fourth storage unit 240, 242. This is determined by the control unit for coating film formation area 254.

The coating chamber 208 has the conventionally known structure. The coating chamber 208 is arranged to coat the intermediate product α and the intermediate product β by spraying coating fluid from a plurality of coating guns 258, while the intermediate products α and β are supported by the first and second intermediate product retaining devices 216, 218 and circulated in the coating film forming apparatus 14 in one direction (direction indicated by an arrow in Fig. 1) while being rotated around a center shaft of the first and second intermediate product retaining devices 216, 218.

Then, as shown in Fig. 1, the intermediate product α and the intermediate product β that have the coated surface are moved into the drying chamber 210 to be dried. Thus, the intended resin product is produced. Hereinafter, the intermediate product α with the coated surface is referred to as a resin product α, and the intermediate product β with the coated surface is referred to as a resin product β.

The resin product α or β removed from the drying chamber 210 is detached from the first or second intermediate product retaining device 216, 218 by a robot arm 268 of a resin product removal device 266 and moved onto a product transfer device 270 including a belt conveyor, for example. Then, the resin product α and the resin product β on the product transfer device 270 are sent to an inspection room 272 and checked for the presence of the defective product.

In the manufacturing system of the resin product having the above-described structure in accordance with the present embodiment, the intended resin product α and the resin product β, which have different shapes, are produced as follows.

Initially, the substrate α and the substrate β having different shapes are formed by the first and second injection molding apparatuses 10a, 10b in a predetermined order. Then, the substrate α and the substrate β are transferred by the transfer conveyor 32 to the terminal point of the transfer conveyor 32 in the order of the formation. After that, each of the substrates α and β is moved from the terminal point of the transfer conveyor 32 to the terminal side supporting station 60e of the first roller conveyor 54a of the transfer line 16 and supported by the first substrate-retaining device 52 and the second substrate-retaining device 53.

Subsequently, the first substrate-retaining device 52 retaining the substrate α and the second substrate-retaining device 53 retaining the substrate β are transferred to the first middle supporting station 60g of the second roller conveyor 54b by the transfer line 16. Then, the substrates α and β retained by the first and second substrate-retaining devices 52, 53 on the first middle supporting station 60g are transferred into the metal film deposition apparatus 12. Therein, a metal film is formed on the surface of the substrate α and the substrate β to obtain the intermediate product α and the intermediate product β having different shapes. Then, the intermediate products α and β are returned to (the pallet 70 of) the first substrate-retaining device 60 and (the pallet 70 of) the second substrate-retaining device 53 supported on the first middle supporting station 60f of the transfer line 16 to be retained thereon.

Then, the first substrate-retaining device 52 retaining the substrate α and the second substrate-retaining device 53 retaining the substrate β are transferred to the start side supporting station 60a of the first roller conveyor 54a by the transfer line 16. The intermediate product α retained by the first substrate-retaining device 52 and the intermediate product β retained by the second substrate-retaining device 53 are moved to the carry-in station 237 of the circulation device 206 from the start side supporting station 60a by the carry-in device 239 so as to be in the coating film forming apparatus 14, and the intermediate product α is retained by the first intermediate product retaining device 216 and the intermediate product β is retained by the second intermediate product retaining device 218, which are supported on the carry-in station 237.

The first intermediate product retaining device 216 retaining the intermediate product α and the second intermediate product retaining device 218 retaining the intermediate product β are circulated in the coating film forming apparatus 14 by the circulation device 206. During the circulation, the coating film is formed on a surface of each of the intermediate products α and β in the coating chamber 208, and the coating films formed on the surface of the intermediate products α and β are dried, thereby obtaining the intended resin products α and β having a different shape.

In the above-described manufacturing system of the resin product in accordance with the present embodiment, upon suspension of the operation (travel of the chain conveyor 212) of the circulation device 206 of the coating film deposition chamber 14, the operation of the carry-in device 239 is suspended under the control of the control unit for coating film formation area 254. Here, the control unit for coating film formation area 254 constitutes a third control unit. Further, in the case where the spraying of the coating fluid by the coating guns 258 and the operation of a dryer (not shown) of the drying chamber, in the coating chamber 208, are stopped due to the reason other than the suspension during normal operation, the operation of the circulation device 206 is suspended under the control of the control unit for coating film formation area 254.

Further, in the case where the first or second substrate-retaining devices 52, 53 having the intermediate product α or β returned by the transfer machine 152 of the metal film deposition apparatus 12 is not sent from the first middle supporting station 60g to the second middle supporting station 60h of the transfer line 16, as described above, the operations of the sputtering apparatus 150 and the transfer machine 152 are suspended.

If the first or second substrate-retaining device 52, 53 is not transferred from the first middle supporting station 60g of the transfer line 16, the first or second substrate-retaining device 52, 53 on the start side supporting station 60f or the terminal side supporting station 60e that is positioned at the upper stream of the first middle supporting station 60g is not transferred and stacked up on the supporting station 60f, 60e. At that time, the operations of the transfer device 41 and the first and second injection molding apparatuses 10a, 10b in the molding area 18 are suspended.

As apparent from the above explanation, in the manufacturing system of the resin product in accordance with the present embodiment, all processes from the molding of the substrates α and β to the production of the resin products α and β are automated. Thus, it can effectively eliminate the manual work in each process. The control unit for molding area 44, the control unit for transfer area 66, the control unit for metal film deposition area 204, and the control unit for coating film formation area 254 work in cooperation to control all of the apparatuses and devices.

Therefore, when some sort of trouble is arisen and the process time is exceeded or the process is suspended during any one of the processes including: the molding process of the substrate α or β; the transfer process of the substrate α or β into the metal film deposition apparatus 12; the production process of the intermediate product α or β by the metal film deposition apparatus 12; the transfer process of the intermediate product α or β into the coating film forming apparatus 14; and the production process of the resin product α or β by the coating film forming apparatus 14, the operations of all apparatuses in the upstream side are suspended while all apparatuses in the downstream side are kept operating. Therefore, when the trouble is arisen, for example, extra substrates or intermediate products are not produced. Thus, there is no need to move the extra substrates or intermediate products to a place other than the transfer line 16 in order to store them as intermediate stocks.

Even if the time required for the production of the resin product α and the resin product β are varied due to the difference of the molding cycle between the substrate α and the substrate β and difference of the production cycle between the intermediate product α and the intermediate product β, the time can be equalized by automatically suspending the operation of each of the apparatuses and devices, or by automatically keeping the substrate or the intermediate product waiting temporarily on the transfer line 16. Consequently, in the production of the two kinds of resin products α and β, it is not necessary to move the substrates or the intermediate products from the transfer line 16 to another place to store them temporarily as the intermediate products.

Accordingly, the resin product manufacturing system of the present embodiment can effectively eliminate manual works and intermediate stocks in the manufacturing process, not only in the manufacture of one kind of the resin product, but also in the manufacture of two kinds of resin products α and β that have different shapes and cycles of steps in the manufacturing process. As a result, labor cost for manufacturing the resin products α and β can be effectively reduced, and a lot of equipments and a large space for storing the intermediate stocks can be advantageously eliminated. Consequently, regardless of the number of kinds, the intended resin products can be effectively manufactured at a low cost.

In the present embodiment, the first and second substrate-retaining devices 52, 53 are removed from the first and second storage units 124, 126 in the molding order of the substrate α and the substrate β under the control of the control unit for transfer area 66. Thus, the substrate α and the substrate β can be smoothly and effectively retained by the first and second substrate-retaining devices 52, 53, and eventually the various operations in the production of the intended resin products α and β can be smoothly and effectively performed.

In addition, in the present embodiment, the metal film is formed on the substrates α and β under suitable condition that is automatically selected. Thus, the intended resin products α and β are more smoothly and effectively produced.

While the specific embodiments of the present invention has been described in detail, for illustrative purpose only, it is to be understood that the present invention is not limited to the details of the illustrated embodiments.

For example, the transfer line 16 may consist of two independent apparatuses, i.e., the two independent apparatuses may consist of the first transfer apparatus and the second transfer apparatus, respectively including the substrate transfer section that extends from the position close to the molding area 18 to the position close to the metal film deposition area 20 and the intermediate product transfer section that extends from the position close to the metal film deposition area 20 to the position close to the coating film formation area 22.

In that case, the second substrate-supporting station and the first intermediate product supporting station are independent from each other. Further, for example, the retaining jig transfer section that extends from the position close to the coating film formation area 22 to the position close to the molding area 18 may be further provided, and the first storage unit 124 and the second storage unit 126 may be provided therein.

Any conventionally known transfer device other than the roller conveyor such as a belt conveyor may constitute the transfer line 16.

Further, each of the supporting stations may have a sequential transfer mechanism that is operated by a separate actuator.

Further, the structure of each of the first retaining jig for retaining the substrate and the second retaining jig for retaining the intermediate product is not limited to the exemplified one. The first and second retaining jigs may not be provided if the first and second transfer apparatuses can transfer the substrate and the intermediate product without the retaining jig.

The control unit for molding area 44, the control unit for transfer area 66, the control unit for metal film deposition area 204, and the control unit for coating film formation area 254 may be constituted by one or two or three control unit(s) having the functions of the at least two of the functions of the control units 44, 66,204,254.

Although further details will not be described herein, it is to be understood that the present invention may be embodied with various other changes and modifications which may occur to those skilled in the art, without departing from the spirit and scope of the invention.

## Claims

1. A resin product manufacturing system comprising:
at least one molding apparatus (10a, 10b) for forming substrates made of resin molded articles;
a metal film deposition apparatus (12) for forming a metal film on a surface of each of the substrates by sputtering to obtain intermediate products;
a coating film forming apparatus (14) for forming a coating film on the metal film of each of the intermediate products to obtain resin products;
a first transfer apparatus including a plurality of substrate supporting stations (60e, 60f, 60g) each capable of supporting one of the substrates and each provided with a substrate transfer mechanism (56a, 56b, 62, 57a, 57b, 58a, 58b, 59a to 59h) for transferring the substrates in sequence, the first transfer apparatus being arranged such that the substrate transfer mechanism of one of adjacent two substrate supporting stations that is positioned at the upstream side starts to transfer one of the substrates after the substrate transfer mechanism of the other one of adjacent two substrate supporting stations that is positioned at the downstream side completes the transfer of one of the substrates;
a second transfer apparatus including a plurality of intermediate product supporting stations (60g, 60h, 60i, 60j, 60a) each capable of supporting one of the intermediate products and each provided with an intermediate product transfer mechanism (56a, 56b, 62, 57a, 57b, 58a, 58b, 59a to 59h) for transferring the intermediate products in sequence, the second transfer apparatus being arranged such that the intermediate product transfer mechanism of one of adjacent two intermediate product supporting stations that is positioned at the upstream side starts to transfer one of the intermediate products after the intermediate product transfer mechanism of the other one of adjacent two intermediate product supporting stations that is positioned at the downstream side completes the transfer of one of the intermediate products;
a substrate removal apparatus (36a, 36b, 32, 41) for removing the substrates from the at least one molding apparatus and allowing each of the substrates to be supported by a first substrate supporting station (60e), which is one of the plurality of substrate supporting stations;
a substrate carrying machine (152) for carrying the substrates each supported by a second substrate supporting station (60g) into the metal film deposition apparatus, the second substrate supporting station being one of the plurality of substrate supporting stations that is positioned at the downstream side of the first substrate supporting station in the transfer direction of the substrates;
an intermediate product removal machine (152) for removing the intermediate products from the metal film deposition apparatus and allowing each of the removed intermediate products to be supported by a first intermediate product supporting station (60g), which is one of the plurality of intermediate product supporting stations;
an intermediate product carrying machine (239) for carrying the intermediate products each supported by a second intermediate product supporting station (60a) into the coating film forming apparatus, the second intermediate product supporting station being one of the plurality of intermediate product supporting stations that is positioned at the downstream side of the first intermediate product supporting station in the transfer direction of the intermediate products;
a first control unit (44) for controlling the substrate removal apparatus such that the substrate removal apparatus starts its operation upon completion of the transfer of one of the substrates by the substrate transfer mechanism of the first substrate supporting station;
a second control unit (204) for controlling each of the intermediate product removal apparatus, the substrate carrying machine, and the metal film deposition apparatus, such that the intermediate product removal apparatus starts its operation upon completion of the transfer of one of the intermediate products by the intermediate product transfer mechanism of the first intermediate product supporting station, and such that the substrate carrying machine and the metal film deposition apparatus are operated in conjunction with the operation of the intermediate product removal apparatus; and
a third control unit (254) for controlling the intermediate product carrying machine such that the operation of the intermediate product carrying machine is suspended when the operation of the coating film forming apparatus is suspended.

2. The resin product manufacturing system according to claim 1, wherein the at least one molding apparatus comprises a plurality of molding apparatuses, and each of the plurality of molding apparatuses arranged to form a different kind of substrate having a different shape, whereby plural kinds of intermediate products having different shapes are obtained after the formation of the metal film on the surface of each of plural kinds of substrates.

3. The resin product manufacturing system according to claim 2, further comprising:
a plurality of first retaining jigs (52, 53) each transferred by the first transfer apparatus while retaining each of the substrates;
plural kinds of first retaining portions (106, 108) each capable of retaining each of the substrates, each of the first retaining portions being provided on the plurality of first retaining jigs and having a different shape depending on the kind of substrate to be retained;
a first jig stocker (124, 126) arranged to store the plurality of first retaining jigs therein and remove any one of the plurality of first retaining jigs therefrom to be transferred onto one of the plurality of substrate supporting stations of the first transfer apparatus; and
a first decision unit (66) for determining the removal order of the plurality of first retaining jigs from the first jig stocker, based on the molding order of the plural kinds of substrates, such that the plurality of first retaining jigs provided with the first retaining portions are removed in sequence from the first jig stocker in the same order as the molding order of the plural kinds of substrates.

4. The resin product manufacturing system according to claim 3, wherein, every time the plural kinds of substrates are formed by the plurality of molding apparatuses, the plurality of molding apparatuses output a plural kinds of substrate molding signals corresponding to the kinds of substrates formed, and based on the plural kinds of substrate molding signals, the first decision unit determines the kind of first retaining jig to be removed from the first jig stocker.

5. The resin product manufacturing system according to claim 3 or claim 4, wherein the first retaining portion is rotatably provided on a body (72) of each of the plurality of first retaining jigs and a rotation mechanism (190, 102, 186, 104, 188) for rotating the first retaining portion is provided in the metal film deposition apparatus, whereby the metal film is formed on each of the substrates in the metal film deposition apparatus while each of the substrates is rotated together with the first retaining portion rotated by the rotation mechanism, and wherein a positioning mechanism (121, 123, 84a, 84b, 104, 74) is provided for positioning the first retaining portion that retains each of the intermediate products including the metal film at a reference rotation position.

6. The resin product manufacturing system according to any one of claims 2 to 5, further comprising: a discrimination unit (204) for discriminating the kind of substrate to be transferred into the metal film deposition apparatus by the substrate transfer apparatus and outputting plural kinds of discrimination signals corresponding to the kind of substrate to be transferred; and a second decision unit (204) for selecting and determining a deposition condition depending on the kind of substrate to be transferred into the metal film deposition apparatus among plural kinds of deposition conditions of the metal film in the metal film deposition apparatus, based on the discrimination signals outputted from the discrimination unit, whereby the metal film is formed under the deposition condition that is suitable to the kind of substrate transferred into the metal film deposition apparatus.

7. The resin product manufacturing system according to any one of claims 2 to 6, further comprising:
a plurality of second retaining jigs (216, 218) each transferred into the coating film forming apparatus while retaining each of the intermediate products;
plural kinds of second retaining portions (222, 226) each capable of retaining each of the intermediate products, each of the plurality of second retaining portions being provided on the plurality of second retaining jigs and having a different shape depending on the kind of substrate to be retained;
a second jig stocker (240, 242) arranged to store the plurality of second retaining jigs therein and remove any one of the plurality of second retaining jigs therefrom to be transferred into the coating film forming apparatus; and
a third decision unit (254) for determining the removal order of the plurality of second retaining jigs from the second jig stocker, based on the production order of the plural kinds of the intermediate products, such that the plurality of second retaining jigs each including the second retaining portion are removed in sequence from the second jig stocker in the same order as the production order of the plural kinds of the intermediate products.
